# EUROPÄISCHE PATENTANMELDUNG

(11) **EP 4 404 116 A1**
(43) Veröffentlichungstag der Anmeldung: **24.07.2024**
(21) Anmeldenummer: 23152707.8
(22) Anmeldetag: 20.01.2023
(51) Int. Cl.: G06Q 10/0631, G06Q 10/08, G06F 30/20, G06F 30/30

(54) **VERFAHREN ZUM ANLEGEN EINER WARENLOGISTIKEINRICHTUNG, COMPUTERLESBARES SPEICHERMEDIUM UND WARENLOGISTIKEINRICHTUNG**

(71) Anmelder: Jungheinrich Aktiengesellschaft, 22047 Hamburg (DE)
(72) Erfinder: HARING, Stefan, 8510 Stainz (AT); LUTTENBERGER, Jürgen, 8435 Wagna (AT)
(74) Vertreter: Seemann & Partner Patentanwälte mbB

(57) **Zusammenfassung**

Die Erfindung betrifft ein Verfahren zum Anlegen einer Warenlogistikeinrichtung (2) sowie eine entsprechende Warenlogistikeinrichtung (2). Das Verfahren umfasst die Schritte: Erstellen (S1) einer der Warenlogistikeinrichtung (2) zugeordneten Logistikeinrichtung-Projekt-Datei (4), Einfügen (S2) und Speichern von Daten, die Eigenschaften zumindest einer der folgenden Komponenten der Warenlogistikeinrichtung (2) beschreiben, in die Logistikeinrichtung-Projekt-Datei 4 und Realisieren (S4) der Warenlogistikeinrichtung (2) unter Verwendung der in der Logistikeinrichtung-Projekt-Datei (4) gespeicherten Daten, wobei zumindest eine die Warenlogistikeinrichtung (2) im Hinblick auf ihre konstruktiven, geometrischen und/oder funktionellen Eigenschaften beeinflussende oder im Hinblick auf einen Zustand der Warenlogistikeinrichtung (2) überwachende Maßnahme während des Lebenszyklus der Warenlogistikeinrichtung (2) unter Verwendung der in der Logistikeinrichtung-Projekt-Datei (4) gespeicherten Daten durchgeführt wird.

## Beschreibung

Die Erfindung betrifft ein Verfahren zum Anlegen einer Warenlogistikeinrichtung, ein computerlesbares Speichermedium sowie eine Warenlogistikeinrichtung.

Warenlogistikeinrichtungen, wie beispielsweise ein Lager- oder Umschlag-Terminal, umfassen ein Bauwerk, in welchem beispielsweise ein Warenlager oder eine Warensortierstation vorhanden sind. In das Bauwerk sind ferner Logistik-Infrastrukturelemente integriert, beispielsweise Rolltore, Signalleuchten oder Ladestationen für elektrisch betriebene Flurförderzeuge. In der Warenlogistikeinrichtung werden ferner Intralogistik-Warentransportvorrichtungen betrieben, bei denen es sich neben den beispielhaft bereits genannten Flurförderzeugen auch um Förderstrecken wie beispielsweise Bandförderer handeln kann. Damit die Logistik-Infrastrukturelemente und die Intralogistik-Warentransportvorrichtungen in der gewünschten Weise zusammenwirken, werden in einer Warenlogistikeinrichtung Fahrbereiche und Transportwege festgelegt, die von den Flurförderzeugen befahren werden. Die in der Warenlogistikeinrichtung vorhandenen Logistik-Infrastrukturelemente und Intralogistik-Warentransportvorrichtungen einschließlich des Bauwerks der Warenlogistikeinrichtung sollen als Komponenten der Warenlogistikeinrichtung bezeichnet werden.

Bei der Planung und Realisierung einer Warenlogistikeinrichtung sind eine Vielzahl von Aspekten zu berücksichtigen. Die Planung erfolgt daher in vielen Fällen unter Verwendung einer Planungssoftware.

Aufgabe der Erfindung ist es, ein Verfahren zum Anlegen einer Warenlogistikeinrichtung, ein computerlesbares Speichermedium sowie eine Warenlogistikeinrichtung anzugeben, wobei Daten, die eine Komponente der Warenlogistikeinrichtung beschreiben, besser nutzbar gemacht werden soll.

Die Aufgabe wird gelöst durch ein Verfahren zum Anlegen einer Warenlogistikeinrichtung, welches die folgenden Schritte umfasst:
- Erstellen einer der Warenlogistikeinrichtung zugeordneten Logistikeinrichtung-Projekt-Datei,
- Einfügen und Speichern von Daten, die Eigenschaften zumindest einer der folgenden Komponenten der Warenlogistikeinrichtung beschreiben, in die Logistikeinrichtung-Projekt-Datei:
- konstruktive Eigenschaften eines Bauwerks der Warenlogistikeinrichtung,
- geometrische und/oder funktionelle Eigenschaften von Fahrbereichen und/oder Transportwegen in der Logistikeinrichtung,
- geometrische und/oder funktionelle Eigenschaften von Logistik-Infrastrukturelementen der Warenlogistikeinrichtung,
- geometrische und/oder funktionelle Eigenschaften von in der Warenlogistikeinrichtung eingesetzten Intralogistik-Warentransportvorrichtungen, insbesondere Flurförderzeugen,
- Erstellen eines Planungsmodells der Warenlogistikeinrichtung unter Verwendung der in der Logistikeinrichtung-Projekt-Datei gespeicherten Daten,
- Realisieren der Warenlogistikeinrichtung auf der Grundlage des Planungsmodells und unter Verwendung der in der Logistikeinrichtung-Projekt-Datei gespeicherten Daten, wobei
- zumindest eine die Warenlogistikeinrichtung im Hinblick auf ihre konstruktiven, geometrischen und/oder funktionellen Eigenschaften beeinflussende oder im Hinblick auf einen Zustand der Warenlogistikeinrichtung überwachende Maßnahme während des Lebenszyklus der Warenlogistikeinrichtung unter Verwendung der in der Logistikeinrichtung-Projekt-Datei gespeicherten Daten durchgeführt wird.

Das Verfahren ist insbesondere ein computerimlementiertes Verfahren.

Konstruktive Eigenschaften des Bauwerks der Warenlogistikeinrichtung sind beispielsweise die Abmessungen oder Maße des Bauwerks oder Baukörpers, allgemein auch als geometrische Daten des Bauwerks bezeichnet. Bei den geometrischen Daten handelt es sich insbesondere um maßstabsgetreue Daten. Weitere konstruktive Eigenschaften können beispielsweise die Tragfähigkeit oder Belastbarkeit einzelner Strukturen oder Komponenten des Bauwerks sein. Konstruktive Eigenschaften des Bauwerks sind insbesondere solche Eigenschaften, die stets das Bauwerk selbst und nicht seine Nutzung betreffen.

Geometrische Eigenschaften von Fahrbereichen oder Transportwegen sind beispielsweise der Verlauf, die Lage, Abmessungen und/oder Maße der Transportwege. Auch diese geometrischen Daten können maßstabsgetreue Daten sein und beispielsweise eine Position, Abmessungen oder einen Verlauf der Fahrbereiche und Transportwege innerhalb der Logistikeinrichtung festlegen.

Funktionelle Eigenschaften von Fahrbereichen sind beispielsweise eine erlaubte maximale Geschwindigkeit, eine maximal mögliche Durchfahrthöhe, eine maximale Anzahl von beispielsweise in einem Fahrbereich zugelassenen Flurförderzeugen oder der Fahrzeugtyp bzw. die Fahrzeugtypen, welcher in einem bestimmten Fahrbereich zugelassen ist/sind. In einem Fahrbereich können konkrete Fahrspuren definiert werden. Einer Fahrspur kann eine vorgegebene Fahrtrichtung, in der diese zu befahren ist, zugewiesen werden.

Logistik-Infrastrukturelemente sind beispielsweise Regale, Ladehilfsmittel-Stationen, also Bereiche, in denen Ladehilfsmittel wie beispielsweise Paletten aufgenommen und abgestellt werden, Ladestationen zum Aufladen von elektrisch betriebenen Flurförderzeugen, Bodenabstellplätze, Übergabeplätze oder -bereiche, wie beispielsweise Rampen, Parkpositionen sowie Tore, Ampeln, Rolltore, Brandschutztore, Durchfahrtbereiche, Taster zum manuellen Auslösen von Transportfahrten und dergleichen. Als Logistik-Infrastrukturelemente sollen insbesondere solche Elemente verstanden werden, die fest mit dem Bauwerk der Warenlogistikeinrichtung verbunden sind und mit dem innerhalb der Warenlogistikeinrichtung stattfindenden Warenfluss in Wechselwirkung stehen. Logistik-Infrastrukturelemente sind insbesondere ortsfest in der Warenlogistikeinrichtung angeordnet oder montiert.

Geometrische Eigenschaften von Logistik-Infrastrukturelementen sind beispielsweise deren Abmessungen und Position innerhalb der Warenlogistikeinrichtung, eine maximale Durchfahrtbreite und/oder - höhe beispielsweise eines Tors, einer Durchfahrt oder eines Durchgangs.

Funktionelle Eigenschaften von Logistik-Infrastrukturelementen sind beispielsweise die Fähigkeit eines Rolltors sich automatisch zu öffnen oder für die manuelle Bedienung vorgesehen zu sein. Eine weitere funktionelle Eigenschaft kann der Zeitraum sein, der für das Öffnen bzw. Schließen des Rolltors benötigt wird. Dieser Parameter kann im System berücksichtigt werden, so dass das Rolltor so rechtzeitig öffnet, dass ein Durchfahren des Rolltors möglich ist, ohne dass beispielsweise ein Flurförderzeug abbremsen muss. Eine weitere funktionelle Eigenschaft eines Logistik-Infrastrukturelements kann beispielsweise der maximal an einer Ladestation bereitstellbare Ladestrom sein.

Intralogistik-Warentransportvorrichtungen sind insbesondere Flurförderzeuge. Als Intralogistik-Warentransportvorrichtungen werden aber auch Regalbediengeräte, Blocklageranlagen, Förderstrecken, Bandförderer und dergleichen angesehen. Intralogistik-Warentransportvorrichtungen sind zum Warentransport innerhalb der Warenlogistikeinrichtung vorgesehen und eingerichtet, sie treiben den innerhalb der Warenlogistikeinrichtung stattfindenden Warenfluss.

Geometrische Eigenschaften von Intralogistik-Warentransportvorrichtungen sind beispielsweise die Maße oder Abmessungen eines Flurförderzeugs oder auch die Abmessungen und die Position beispielsweise einer Förderstrecke oder eines Bandförderers.

Funktionelle Eigenschaften der Intralogistik-Warentransportvorrichtungen sind beispielsweise eine maximale Geschwindigkeit eines Flurförderzeugs, ein minimaler oder maximaler Kurvenradius des Flurförderzeugs, eine maximale Kurvengeschwindigkeit, eine maximale Hubhöhe oder eine zulässige Traglast des Flurförderzeugs. Funktionelle Eigenschaften von Intralogistik-Warentransportvorrichtungen, bei denen es sich nicht um Flurförderzeuge handelt, also beispielsweise von einem Bandförderer, sind beispielsweise eine Förderkapazität, eine Förderrichtung oder Fördergeschwindigkeit.

Die Logistikeinrichtung-Projekt-Datei wird abgesehen von der Planung und Realisierung der Warenlogistikeinrichtung für zumindest eine weitere Maßnahme während des Lebenszyklus der Warenlogistikeinrichtung verwendet. Dies ist vorteilhaft, da auf diese Weise die in der Logistikeinrichtung-Projekt-Datei gespeicherten Daten, welche vielfach mit großem Aufwand erzeugt und in die Datei eingepflegt wurden, während dieser weiteren Entwicklungsphase verwendet werden können. Dies bedeutet einen enormen Effizienzfortschritt, da die doppelte Erhebung von Daten entfällt. Während der Durchführung der weiteren Maßnahme, welche während der Lebensdauer der Logistikeinrichtung durchgeführt wird, müssen also mit anderen Worten Daten, die bereits während der Planung und Realisierung der Warenlogistikeinrichtung erhoben wurden, nicht nochmals erhoben werden. Neben dem erheblich verringerten Aufwand für die Erhebung der Daten führt auch die Vereinheitlichung der Datengrundlage durch das Abspeichern der Daten in der Logistikeinrichtung-Projekt-Datei zu erheblichen Fortschritten bei der Effizienz der weiteren Maßnahme. Eine durch die einheitliche Datengrundlage geschaffene Konsistenz zwischen Planung, Realisierung einerseits und der weiteren Maßnahme andererseits, verringert mögliche Fehler während der Planung und Durchführung der Maßnahme und auch während der Planung und Durchführung des Gesamtprojekts.

Gemäß einer Ausführungsform wird die Logistikeinrichtung-Projekt-Datei für sämtliche während des Lebenszyklus der Warenlogistikeinrichtung durchgeführten Maßnahmen verwendet. Somit dient diese Datei als zentraler Aufbewahrungsort für alle relevanten Daten, die im Zusammenhang mit der Warenlogistikeinrichtung gebraucht werden.

Im Kontext der vorliegenden Beschreibung ist unter dem Begriff "Logistikeinrichtung-Projekt-Datei" nicht notwendigerweise eine einzelne Datei im Sinne eines einzelnen Dokuments zu verstehen. Es kann sich vielmehr um eine Sammlung einer Vielzahl von Dateien handeln, welche an einem zentralen Aufbewahrungsort, nämlich der Logistikeinrichtung-Projekt-Datei, zusammengefasst sind.

Gemäß einer vorteilhaften Ausführungsform ist das Verfahren dadurch fortgebildet, dass als Maßnahme die folgenden Schritte ausgeführt werden:
- Simulieren eines Betriebs der Warenlogistikeinrichtung in dem Planungsmodell der Warenlogistikeinrichtung,
- Optimieren des Planungsmodells der Warenlogistikeinrichtung basierend auf einem Ergebnis der Simulation,
- Aktualisieren der in der Logistikeinrichtung-Projekt-Datei vorhandenen Daten anhand der Ergebnisse der Optimierung,
- Erstellen eines finalisierten Planungsmodells der Warenlogistikeinrichtung und
- Abspeichern der Modell-Daten des finalisierten Planungsmodells in der Logistikeinrichtung-Projekt-Datei, wobei insbesondere
- die Logistikeinrichtung-Projekt-Datei umfasst: geometrische Daten, welche zu befahrende Transportwege in der Warenlogistikeinrichtung beschreiben, und geometrische Daten zu einer Mehrzahl von Logistik-Infrastrukturelementen, die mit den Intralogistik-Warentransportvorrichtungen zusammenwirken, insbesondere von Warenübergabestationen, Ladestationen, Parkpositionen, Abstellplätzen und/oder Lagerplätzen, wobei der Schritt des Simulierens des Betriebs der Warenlogistikeinrichtung eine Validierung der zu befahrenden Transportwege umfasst, wobei insbesondere bei der Validierung der zu befahrenden Transportwege überprüft wird, ob ein ferner insbesondere vollständiger, durchgehend befahrbarer Fahrspuren-Graph erstellt werden kann, der zumindest einen Teil der Logistik-Infrastrukturelemente, ferner insbesondere alle Logistik-Infrastrukturelemente, miteinander verbindet.

Die Simulation des Betriebs der Warenlogistikeinrichtung wird bevorzugt vor der Realisierung der Warenlogistikeinrichtung durchgeführt. Sie erfolgt auf Grundlage des Planungsmodells. Mit anderen Worten wird also gemäß einer solchen Ausführungsform die Warenlogistikeinrichtung auf der Grundlage des finalisierten Planungsmodells realisiert. Bei der Erzeugung eines Fahrspuren-Graphs kann außerdem überprüft werden, ob für die vorgesehenen Flurförderzeuge, in Anbetracht der Dimensionierung beispielsweise der Fahrbereiche, die vorgeschriebenen oder vorgesehenen Abstände zu den Nicht-Fahrbereichen eingehalten werden. Dies betrifft beispielsweise die vorgeschriebenen Abstände zu baulichen Strukturen wie beispielsweise den Wänden des Gebäudes. Ferner kann beispielsweise überprüft werden, ob der festgelegte Fahrspuren-Graph von dem geplanten Typ des Flurförderzeugs überhaupt befahren werden kann.

Durch eine Simulation des Betriebs der Warenlogistikeinrichtung kann deren Funktionalität und Leistungsfähigkeit detailliert betrachtet und analysiert werden. Das Planungsmodell kann im Hinblick auf die Funktionalität und Leistungsfähigkeit der Warenlogistikeinrichtung optimiert werden, so dass mögliche Einschränkungen der Warenlogistikeinrichtung bereits vor deren Realisierung ausgeräumt werden könnten. Vorteilhaft erfolgen alle Schritte von der Planung über die Simulation und die Optimierung bis hin zur Realisierung der Warenlogistikeinrichtung auf der Grundlage der in der Logistikeinrichtung-Projekt-Datei gespeicherten Daten.

Gemäß einer weiteren vorteilhaften Ausführungsform ist das Verfahren dadurch fortgebildet, dass als Maßnahme die folgenden Schritte ausgeführt werden: Erstellen einer Materialliste und/oder einer Liste erforderlicher Bauleistungen für die Realisierung der Warenlogistikeinrichtung unter Verwendung der in der Logistikeinrichtung-Projekt-Datei gespeicherten Daten, Erstellen einer Kosteschätzung für die Realisierung der Warenlogistikeinrichtung unter Verwendung der Materialliste und/oder der Liste erforderlicher Bauleistungen.

In der Materialliste sind konkret für die Realisierung der Warenlogistikeinrichtung vorgesehene Komponenten, Bauteile und Materialien genannt und insbesondere im Hinblick auf ihre Eigenschaften beschrieben. Bauleistungen, welche in der Liste der erforderlichen Bauleistungen aufgeführt sind, sind insbesondere solche, die zur Verarbeitung der in der Materialliste genannten Waren bei der Erstellung der Warenlogistikeinrichtung erforderlich sind. Beispielsweise handelt es sich um Handwerkerdienstleistungen oder um Leistungen die von Baumaschinen erbracht werden. Die Möglichkeit auf der Grundlage der Logistikeinrichtung-Projekt-Datei eine Kostenschätzung zu erstellen ist sehr vorteilhaft. Werden Veränderungen in der Planung der Warenlogistikeinrichtung vorgenommen oder wird diese wie oben erwähnt im Hinblick auf eine oder mehrere ihrer Eigenschaften optimiert, kann zu jedem Zeitpunkt eine entsprechende Kostenschätzung abgegeben werden. Diese stellt eine gute Entscheidungsgrundlage dar.

Gemäß einer weiteren vorteilhaften Ausführungsform werden bei dem Verfahren gemäß Aspekten der Erfindung als Maßnahme die folgenden Schritte ausgeführt: Aufnehmen eines Betriebs der Warenlogistikeinrichtung, wobei die Aufnahme des Betriebs ein Konfigurieren und/oder Einlernen der Logistik-Infrastrukturelemente und/oder der Intralogistik-Warentransportvorrichtungen umfasst und das Konfigurieren und/oder Einlernen unter Verwendung der in der Logistikeinrichtung-Projekt-Datei vorhandenen Daten durchgeführt wird.

Mit anderen Worten wird die Logistikeinrichtung-Projekt-Datei oder aus dieser abgeleitete Daten auf eine zentrale Steuereinheit der Warenlogistikeinrichtung übertragen und diese so zur Steuerung der Warenlogistikeinrichtung befähigt. In gleicher Weise wird die Logistikeinrichtung-Projekt-Datei oder aus dieser abgeleitete Daten verwendet um Logistik-Infrastrukturelemente zu konfigurieren, indem diese durch die zentrale Steuereinheit unter Verwendung der Logistik-Projekt-Datei konfiguriert werden und/oder die Logistik-Projekt-Datei oder aus dieser abgeleitete Daten an die Logistik-Infrastrukturelemente zu diesem Zweck übertragen werden.

Vorteilhaft kann die Warenlogistikeinrichtung in Betrieb genommen werden, ohne dass hierzu weitere Daten der Warenlogistikeinrichtung erfasst werden müssen. Die nahtlose Verwendung der in der Logistikeinrichtung-Projekt-Datei gespeicherten Daten erlaubt eine schnelle und effiziente Inbetriebnahme der Warenlogistikeinrichtung.

Ferner kann das Verfahren gemäß einer weiteren Ausführungsform dadurch fortgebildet sein, dass als Maßnahme die folgenden Schritte ausgeführt werden: Steuern eines laufenden Betriebs der Warenlogistikeinrichtung, insbesondere eines Betriebs der Logistik-Infrastrukturelemente und/oder der Intralogistik-Warentransportvorrichtungen, durch einen Steuerrechner, wobei der Steuerrechner eine Steuerung der Warenlogistikeinrichtung unter Verwendung der in der Logistikeinrichtung-Projekt-Datei vorhandenen Daten vornimmt. In gleicher Weise wird die Logistikeinrichtung-Projekt-Datei oder aus dieser abgeleitete Daten verwendet um Logistik-Infrastrukturelemente zu betreiben, indem diese durch die zentrale Steuereinheit unter Verwendung der Logistikeinrichtung-Projekt-Datei gesteuert werden und/oder die Logistikeinrichtung-Projekt-Datei oder aus dieser abgeleitete Daten an die Logistik-Infrastrukturelemente zu diesem Zweck übertragen werden.

Auch die laufende Betriebssteuerung kann also nahtlos und auf der Grundlage der in der Logistikeinrichtung-Projekt-Datei gespeicherten Daten oder daraus abgeleiteten Daten vorgenommen werden.

Gemäß einer weiteren vorteilhaften Ausführungsform ist das Verfahren dadurch fortgebildet, dass als Maßnahme die folgenden Schritte durchgeführt werden:
- Visualisieren der Warenlogistikeinrichtung im Betrieb unter Verwendung der in der Logistikeinrichtung-Projekt-Datei vorhandenen Daten oder daraus abgeleiteten Daten, wobei
- die Logistikeinrichtung-Projekt-Datei insbesondere umfasst:
- Abmessungen des Bauwerks als konstruktive Eigenschaften des Bauwerks,
- Abmessungen und/oder Positionen von Logistik-Infrastrukturelementen als geometrische Eigenschaften der Logistik-Infrastrukturelemente und
- Abmessungen von Intralogistik-Warentransportvorrichtungen als geometrische Eigenschaften der Intralogistik-Warentransportvorrichtungen, wobei
- die Visualisierung eine grafische Darstellung des Bauwerks der Warenlogistikeinrichtung umfasst, und wobei eine Geometrie dieser Darstellung unter Berücksichtigung der Abmessungen des Bauwerks erfolgt, insbesondere in zumindest näherungsweise maßstabsgetreuer Darstellung, ferner insbesondere in exakt maßstabsgetreuer Darstellung, erfolgt,
- die Visualisierung eine grafische Darstellung der Logistik-Infrastrukturelemente unter Berücksichtigung der Abmessungen, insbesondere in zumindest näherungsweise maßstabsgetreuer Darstellung, und/oder der Positionen der Logistik-Infrastrukturelemente umfasst, und
- die Visualisierung eine grafische Darstellung der Intralogistik-Warentransportvorrichtungen unter Berücksichtigung der Abmessungen, insbesondere in zumindest näherungsweise maßstabsgetreuer Darstellung, der Intralogistik-Warentransportvorrichtungen umfasst und wobei ferner insbesondere
- die Logistikeinrichtung-Projekt-Datei umfasst:
- funktionelle Eigenschaften der in der Warenlogistikeinrichtung vorhandenen Logistik-Infrastrukturelemente und/oder Intralogistik-Warentransportvorrichtungen, wobei die Visualisierung eine Darstellung eines aktuellen Funktionszustands der Logistik-Infrastrukturelemente und/oder der Intralogistik-Warentransportvorrichtungen umfasst und wobei ferner insbesondere
- die Visualisierung eine Darstellung einer aktuellen Position und/oder von Staus der Intralogistik-Warentransportvorrichtungen umfasst.

Eine Visualisierung der Warenlogistikeinrichtung im Betrieb ist für viele Zwecke vorteilhaft. Beispielsweise kann anhand einer solchen Visualisierung sich ein Betriebsleiter der Warenlogistikeinrichtung einen schnellen Überblick über den Zustand der Warenlogistikeinrichtung verschaffen. Ferner liefert die Visualisierung vielfach eine nützliche Grundlage für die Optimierung der Warenlogistikeinrichtung oder die Behebung von technischen Problemen. Durch die Verwendung der in der Logistikeinrichtung-Projekt-Datei hinterlegten Daten oder aus dieser abgeleiteten Daten für die Visualisierung des aktuellen Betriebszustandes der Warenlogistikeinrichtung, kann eine aufwendige Modellierung der Warenlogistikeinrichtung zu diesem Zweck vorteilhaft entfallen.

Die Visualisierung erfolgt bevorzugt anhand der realen Abmessungen und Maße sowohl des Bauwerks der Warenlogistikeinrichtung als auch der Logistik-Infrastrukturelemente und Intralogistik-Warentransportvorrichtungen. So werden beispielsweise und sofern es die Visualisierung zulässt, das Gebäude und die Logistik-Infrastrukturelemente maßstabsgetreu dargestellt. Abweichungen von einer exakt maßstabsgetreuen Darstellung sind im Hinblick auf Übersichtlichkeit und Darstellbarkeit der Gesamtdarstellung jedoch zulässig. Dies betrifft beispielsweise die maßstabsgetreue Darstellung der Intralogistik-Warentransportvorrichtungen. So können beispielsweise bei einem sehr großen Gebäude die Intralogistik-Warentransportvorrichtungen vielfach nicht exakt maßstabsgetreu dargestellt werden, da diese sonst äußerst klein darzustellen wären. Hier sind Abweichungen von einer exakt maßstabsgetreuen Darstellung beabsichtigt und zulässig. Es ist jedoch insbesondere vorgesehen, dass innerhalb einer Klasse von Elementen wiederum eine maßstabsgetreue Darstellung erfolgt oder sich die Darstellung an den realen Abmessungen der entsprechenden Elemente orientiert. Beispielsweise können Logistik-Infrastrukturelemente untereinander maßstabsgetreu oder zumindest in Annäherung an ihre realen Größenverhältnisse abgebildet werden. Mit anderen Worten erscheint beispielsweise ein erstes Rolltor, welches die doppelte Durchfahrtbreite eines zweiten Rolltors aufweist, in der Visualisierung auch doppelt so breit. Gleiches kann für die Intralogistik-Warentransportvorrichtungen gelten. Beispielsweise wird ein erstes Flurförderzeug, welches im Vergleich zu einem zweiten Flurförderzeug größer ist, in der Visualisierung auch größer dargestellt.

Die Visualisierung erfolgt beispielsweise an einem Fahrzeugleitstand. Gemäß einer alternativen Ausführungsform erfolgt die Visualisierung an einem externen Rechner, welcher sich insbesondere außerhalb des Gebäudes der Warenlogistikeinrichtung befindet.

Konkret ist gemäß einer weiteren vorteilhaften Ausführungsform das Verfahren dadurch fortgebildet, dass die Maßnahme des Visualisierens der Warenlogistikeinrichtung ferner umfasst:
- Visualisieren der Warenlogistikeinrichtung an einem mit dem Steuerrechner gekoppelten Fahrzeugleitstand, wobei die Logistikeinrichtung-Projekt-Datei und/oder aus dieser abgeleitete oder extrahierte Daten entweder in dem Fahrzeugleitstand hinterlegt sind oder über eine Datenverbindung zwischen dem Fahrzeugleitstand und dem Steuerrechner an den Fahrzeugleitstand übermittelt werden, wobei insbesondere
- der Steuerrechner einem externen Rechner Zugriff auf die Logistikeinrichtung-Projekt-Datei und/oder die in der Logistikeinrichtung-Projekt-Datei gespeicherten Daten und/oder aus der Logistikeinrichtung-Projekt-Datei abgeleiteten oder extrahierten Daten gewährt und der externe Rechner die Warenlogistikeinrichtung visualisiert, wobei der externe Rechner insbesondere eine aktuelle Position der Intralogistik-Warentransportvorrichtungen und/oder einen Betriebsstatus der Logistik-Infrastrukturelemente visualisiert, um eine Diagnose von Fehlfunktionen der Warenlogistikeinrichtung zu ermöglichen. Die zur Darstellung des Betriebsstatus der Logistik-Infrastrukturelemente erforderlichen Daten erhält der externe Rechner in diesem Zusammenhang von dem Steuerrechner der Warenlogistikeinrichtung.

Der Fernzugriff auf die Visualisierung der Warenlogistikeinrichtung hat sich als ein sehr nützliches Werkzeug herausgestellt, da auf diese Weise beispielsweise ein externer Dienstleister in die Überwachung, Optimierung und gegebenenfalls auch die Wartung der Warenlogistikeinrichtung einbezogen werden kann. Da diesem externen Dienstleister die gleiche Informationsgrundlage wie dem Betreiber der Warenlogistikeinrichtung zur Verfügung steht, verbessert und vereinfacht dies die Zusammenarbeit erheblich.

Gemäß einer weiteren vorteilhaften Ausführungsform ist das Verfahren dadurch fortgebildet, dass als Maßnahme die folgenden Schritte durchgeführt werden: Durchführen einer Fernwartung der Warenlogistikeinrichtung im Betrieb, wobei insbesondere einem bei der Fernwartung verwendeten externen Rechner von dem Steuerrechner Zugriff gewährt wird auf die Logistikeinrichtung-Projekt-Datei und/oder die in der Logistikeinrichtung-Projekt-Datei gespeicherten Daten und/oder aus der Logistikeinrichtung-Projekt-Datei abgeleiteten oder extrahierten Daten, die auf dem Steuerrechner gespeichert sind.

Für die Durchführung einer Fernwartung gelten ähnliche Vorteile wie sie bereits im Hinblick auf die Visualisierung der Warenlogistikeinrichtung an einem externen Rechner erwähnt wurden. Die Kooperation mit einem externen Partner kann erheblich vereinfacht werden.

Da die Anforderungen an Warenlogistikeinrichtungen permanent schwanken, ist es vielfach so, dass nachträgliche Erweiterungen oder Änderungen der Warenlogistikeinrichtung vorgenommen werden müssen. Gemäß einer vorteilhaften Ausführungsform ist das Verfahren fortgebildet, indem als Maßnahme die folgenden Schritte durchgeführt werden:
Erweitern und/oder Ändern der Warenlogistikeinrichtung unter Anpassung der in der Logistikeinrichtung-Projekt-Datei vorhandenen Daten, wobei die Erweiterung und/oder die Änderung zumindest eine der folgenden Maßnahmen umfasst:
- Anpassung von geometrischen Daten, beschreibend das Bauwerk der Warenlogistikeinrichtung, insbesondere von Maßen des Bauwerks,
- Anpassen von geometrischen und/oder funktionelle Eigenschaften der Logistik-Infrastrukturelemente,
- Austauschen und/oder Ergänzen von Intralogistik-Warentransportvorrichtungen oder Änderung eines Typs der Intralogistik-Warentransportvorrichtungen,
- Austauschen und/oder Ergänzen der Logistik-Infrastrukturelemente,
- Verändern von geometrischen Daten, welche erlaubte Fahrbereiche und/oder Transportwege in der Warenlogistikeinrichtung beschreiben,
- Verändern geometrischer Daten und/oder funktioneller Daten der Logistik-Infrastrukturelemente,
- Verändern geometrischer Daten und/oder funktioneller Daten der in der Warenlogistikeinrichtung eingesetzten Intralogistik-Warentransportvorrichtungen.

Vorteilhaft kann auch die Erweiterung der Warenlogistikeinrichtung auf der Grundlage der in der Logistikeinrichtung-Projekt-Datei vorhandenen Daten durchgeführt werden. Dies ist von besonderer Bedeutung, da Warenlogistikeinrichtungen vielfach wechselnden Anforderungsprofilen unterworfen sind. Daher sind Änderungen und Erweiterungen nach der Fertigstellung der Warenlogistikeinrichtung in vielen Fällen erforderlich. Dieser Schritt ist herkömmlich mit erheblichem Aufwand verbunden, da in vielen Fällen eine Vielzahl von Daten neu erfasst werden muss. Da gemäß der genannten Ausführungsform die in der Logistikeinrichtung-Projekt-Datei vorhandenen Daten genutzt werden können, kann eine Änderung und oder Erweiterung der Warenlogistikeinrichtung mit geringem Aufwand vorgenommen werden.

Die Aufgabe wird ferner gelöst durch ein computerlesbares Speichermedium, auf dem eine Logistikeinrichtung-Projekt-Datei zur Verwendung in einem Verfahren nach einem oder mehreren der zuvor genannten Ausführungsform gespeichert ist. Auf das computerlesbare Speichermedium treffen gleiche oder ähnliche Vorteile zu, wie sie bereits im Hinblick auf das Verfahren selbst erwähnt wurden.

Ferner wird die Aufgabe gelöst durch eine Warenlogistikeinrichtung, realisiert auf der Grundlage eines Planungsmodells und unter Verwendung von in einer Logistikeinrichtung-Projekt-Datei gespeicherten Daten, wobei die Logistikeinrichtung-Projekt-Datei Daten umfasst, die Eigenschaften zumindest einer der folgenden Komponenten der Warenlogistikeinrichtung beschreiben:
- konstruktive Eigenschaften eines Bauwerks der Warenlogistikeinrichtung,
- geometrische und/oder funktionelle Eigenschaften von Fahrbereichen und/oder Transportwegen in der Warenlogistikeinrichtung,
- geometrische und/oder funktionelle Eigenschaften von Logistik-Infrastrukturelementen der Warenlogistikeinrichtung,
- geometrische und/oder funktionelle Eigenschaften von in der Warenlogistikeinrichtung eingesetzten Intralogistik-Warentransportvorrichtungen, insbesondere Flurförderzeugen,
- wobei das Planungsmodell der Warenlogistikeinrichtung unter Verwendung der in der Logistikeinrichtung-Projekt-Datei gespeicherten Daten erstellt ist, und die Logistikeinrichtung-Projekt-Datei während des Lebenszyklus der Warenlogistikeinrichtung ferner für zumindest eine Maßnahme verwendet wird, welche die Warenlogistikeinrichtung im Hinblick auf ihre konstruktiven, geometrische und/oder funktionellen Eigenschaften beeinflusst oder im Hinblick auf einen Zustand der Warenlogistikeinrichtung überwacht.

Auch auf die Warenlogistikeinrichtung selbst treffen gleiche oder ähnliche Vorteile und Weiterbildungsmöglichkeiten zu, wie sie bereits im Hinblick auf das Verfahren zum Anlegen der Warenlogistikeinrichtung erwähnt wurden, so dass auf Wiederholungen verzichtet werden soll.

Die Warenlogistikeinrichtung ist ferner dadurch fortgebildet, dass die Logistikeinrichtung-Projekt-Datei für die folgende Maßnahme verwendet wird:
- Simulieren eines Betriebs der Warenlogistikeinrichtung in dem Planungsmodell der Warenlogistikeinrichtung,
- Optimieren des Planungsmodells der Warenlogistikeinrichtung basierend auf einem Ergebnis der Simulation,
- Aktualisieren der in der Logistikeinrichtung-Projekt-Datei vorhandenen Daten anhand der Ergebnisse der Optimierung,
- Erstellen eines finalisierten Planungsmodells der Warenlogistikeinrichtung und
- Abspeichern der Modell-Daten des finalisierten Planungsmodells in der Logistikeinrichtung-Projekt-Datei.

Gemäß einer vorteilhaften Weiterbildung dieser Ausführungsform ist ferner vorgesehen, dass die Logistikeinrichtung-Projekt-Datei umfasst: geometrische Daten, welche zu befahrende Transportwege in der Warenlogistikeinrichtung beschreiben, und geometrische Daten zu einer Mehrzahl von Logistik-Infrastrukturelementen, die mit den Intralogistik-Warentransportvorrichtungen zusammenwirken, insbesondere von Warenübergabestationen, Ladestationen, Parkpositionen, Abstellplätzen und/oder Lagerplätzen, wobei die Logistikeinrichtung-Projekt-Datei verwendet wird um während der Simulation des Betriebs der Warenlogistikeinrichtung eine Validierung der zu befahrenden Transportwege vorzunehmen.

Gemäß einer weiteren vorteilhaften Weiterbildung dieser Ausführungsform ist ferner vorgesehen, dass die Logistikeinrichtung-Projekt-Datei verwendet wird, um bei der Validierung der zu befahrenden Transportwege zu überprüfen, ob ein insbesondere vollständiger, durchgehend befahrbarer Fahrspuren-Graph erstellt werden kann, der zumindest einen Teil der Logistik-Infrastrukturelemente, insbesondere alle Logistik-Infrastrukturelemente, miteinander verbindet.

Auf die Durchführung einer Simulation des Betriebs der Warenlogistikeinrichtung, die bevorzugt mit einem für die Warenlogistikeinrichtung vorgesehenen Steuerrechner oder einem weiteren Rechner vorgenommen wird, treffen gleiche oder ähnliche Vorteile zu, wie sie bereits im Hinblick auf die bezüglich des Verfahrens genannte Ausführungsform erläutert wurden.

Gemäß einer weiteren vorteilhaften Ausführungsform ist ferner vorgesehen, dass die Warenlogistikeinrichtung dadurch fortgebildet ist, dass die Logistikeinrichtung-Projekt-Datei für die folgende Maßnahme verwendet wird:
- Erstellen einer Materialliste und/oder einer Liste erforderlicher Bauleistungen für die Realisierung der Warenlogistikeinrichtung unter Verwendung der in der Logistikeinrichtung-Projekt-Datei gespeicherten Daten,
- Erstellen einer Kostenschätzung für die Realisierung der Warenlogistikeinrichtung unter Verwendung der Materialliste und/oder der Liste erforderlicher Bauleistungen.

Gemäß einer weiteren vorteilhaften Ausführungsform ist die Warenlogistikeinrichtung ferner dadurch fortgebildet, dass die Logistikeinrichtung-Projekt-Datei verwendet wird, um die folgende Maßnahme auszuführen: Aufnehmen eines Betriebs der Warenlogistikeinrichtung, wobei die Aufnahme des Betriebs ein Konfigurieren und/oder Einlernen von Logistik-Infrastrukturelementen und/oder Intralogistik-Warentransportvorrichtungen umfasst und das Konfigurieren und/oder Einlernen unter Verwendung der in der Logistikeinrichtung-Projekt-Datei vorhandenen Daten durchgeführt wird.

Gemäß einer weiteren vorteilhaften Ausführungsform ist ferner vorgesehen, dass die Warenlogistikeinrichtung dadurch fortgebildet ist, dass diese ferner einen Steuerrechner umfasst, der dazu eingerichtet ist, die folgenden Schritte durchzuführen: Steuern eines laufenden Betriebs der Warenlogistikeinrichtung, insbesondere eines Betriebs der Logistik-Infrastrukturelemente und/oder der Intralogistik-Warentransportvorrichtungen, wobei der Steuerrechner eine Steuerung der Warenlogistikeinrichtung unter Verwendung der in der Logistikeinrichtung-Projekt-Datei vorhandenen Daten vornimmt.

Die Warenlogistikeinrichtung umfasst also einen Steuerrechner, dieser ist ferner gemäß einer Ausführungsform dazu eingerichtet die folgenden Schritte durchzuführen:
- Visualisieren der Warenlogistikeinrichtung im Betrieb unter Verwendung der in der Logistikeinrichtung-Projekt-Datei vorhandenen Daten, wobei
- die Logistikeinrichtung-Projekt-Datei insbesondere umfasst:
- Abmessungen des Bauwerks als konstruktive Eigenschaften des Bauwerks,
- Abmessungen und/oder Positionen von Logistik-Infrastrukturelementen als geometrische Eigenschaften der Logistik-Infrastrukturelemente und
- Abmessungen von Intralogistik-Warentransportvorrichtungen als geometrische Eigenschaften der Intralogistik-Warentransportvorrichtungen, wobei
- der Steuerrechner die Visualisierung als eine grafische Darstellung vornimmt, wobei
- eine Geometrie der Darstellung des Bauwerks der Warenlogistikeinrichtung unter Berücksichtigung der Abmessungen des Bauwerks erfolgt, insbesondere in zumindest näherungsweise maßstabsgetreuer Darstellung erfolgt,
- die grafische Darstellung der Logistik-Infrastrukturelemente unter Berücksichtigung der Abmessungen, insbesondere in zumindest näherungsweise maßstabsgetreuer Darstellung, und/oder der Positionen der Logistik-Infrastrukturelemente erfolgt, und
- die grafische Darstellung der Intralogistik-Warentransportvorrichtungen unter Berücksichtigung der Abmessungen, insbesondere in zumindest näherungsweise maßstabsgetreuer Darstellung, der Intralogistik-Warentransportvorrichtungen erfolgt und wobei ferner insbesondere
- die Logistikeinrichtung-Projekt-Datei umfasst:
- funktionelle Eigenschaften der in der Warenlogistikeinrichtung vorhandenen Logistik-Infrastrukturelemente und/oder Intralogistik-Warentransportvorrichtungen, wobei die Visualisierung eine Darstellung eines aktuellen Funktionszustands der Logistik-Infrastrukturelemente und/oder der Intralogistik-Warentransportvorrichtungen umfasst und wobei ferner insbesondere
- die Visualisierung eine Darstellung einer aktuellen Position und/oder von Staus der Intralogistik-Warentransportvorrichtungen umfasst.

Diese Ausführungsform ist vorteilhaft dadurch fortgebildet, dass die Warenlogistikeinrichtung ferner einen Fahrzeugleitstand umfasst, wobei die Visualisierung der Warenlogistikeinrichtung an dem mit dem Steuerrechner gekoppelten Fahrzeugleitstand erfolgt, und wobei die Projekt-Datei und/oder aus dieser abgeleitete Daten entweder in dem Fahrzeugleitstand hinterlegt sind oder über eine Datenverbindung zu dem Steuerrechner an den Fahrzeugleitstand übermittelt wurden.

Gemäß einer weiteren vorteilhaften Ausführungsform ist die Warenlogistikeinrichtung dadurch fortgebildet, dass diese einen Steuerrechner umfasst, der dazu eingerichtet ist einem externen Rechner Zugriff auf die Logistikeinrichtung-Projekt-Datei und/oder die in der Logistikeinrichtung-Projekt-Datei gespeicherten Daten und/oder aus der Logistikeinrichtung-Projekt-Datei abgeleiteten oder extrahierten Daten zu gewähren und der externe Rechner dazu eingerichtet ist die Warenlogistikeinrichtung zu visualisieren, insbesondere eine aktuelle Position der Intralogistik-Warentransportvorrichtungen und/oder einen Betriebsstatus der Logistik-Infrastrukturelemente zu visualisieren, um eine Diagnose von Fehlfunktionen der Warenlogistikeinrichtung zu ermöglichen, und/oder eine Fernwartung durchzuführen.

Gemäß einer weiteren vorteilhaften Ausführungsform ist die Warenlogistikeinrichtung dadurch fortgebildet, dass diese einen Steuerrechner umfasst, der dazu eingerichtet ist die Logistikeinrichtung-Projekt-Datei zur Durchführung der folgenden Maßnahme zu verwenden: Erweitern und/oder Ändern der Warenlogistikeinrichtung unter Anpassung der in der Logistikeinrichtung-Projekt-Datei vorhandenen Daten, wobei die Erweiterung und/oder die Änderung zumindest eine der folgenden Maßnahmen umfasst:
- Anpassung von geometrischen Daten, beschreibend das Bauwerk der Warenlogistikeinrichtung, insbesondere von Maßen des Bauwerks,
- Anpassen von geometrischen und/oder funktionelle Eigenschaften der Logistik-Infrastrukturelemente,
- Austauschen und/oder Ergänzen von Intralogistik-Warentransportvorrichtungen oder Änderung eines Typs der Intralogistik-Warentransportvorrichtungen,
- Austauschen und/oder Ergänzen der Logistik-Infrastrukturelemente,
- Verändern von geometrischen Daten, welche erlaubte Fahrbereiche und/oder Transportwege in der Warenlogistikeinrichtung beschreiben,
- Verändern geometrischer Daten und/oder funktioneller Daten der Logistik-Infrastrukturelemente,
- Verändern geometrischer Daten und/oder funktioneller Daten der in der Warenlogistikeinrichtung eingesetzten Intralogistik-Warentransportvorrichtungen.

Weitere Merkmale der Erfindung werden aus der Beschreibung erfindungsgemäßer Ausführungsformen zusammen mit den Ansprüchen und den beigefügten Zeichnungen ersichtlich. Erfindungsgemäße Ausführungsformen können einzelne Merkmale oder eine Kombination mehrerer Merkmale erfüllen.

Im Rahmen der Erfindung sind Merkmale, die mit "insbesondere" oder "vorzugsweise" gekennzeichnet sind, als fakultative Merkmale zu verstehen.

Die Erfindung wird nachstehend ohne Beschränkung des allgemeinen Erfindungsgedankens anhand von Ausführungsbeispielen unter Bezugnahme auf die Zeichnungen beschrieben, wobei bezüglich aller im Text nicht näher erläuterten erfindungsgemäßen Einzelheiten ausdrücklich auf die Zeichnungen verwiesen wird. Es zeigen:
- Fig. 1: ein Ablaufdiagramm, in welchem einzelne Schritte eines Verfahrens zum Anlegen einer Warenlogistikeinrichtung gezeigt sind,
- Fig. 2: eine schematische Darstellung einer Warenlogistikeinrichtung,
- Fig. 3: eine schematische Darstellung, welche die Erstellung eines Planungsmodells der Warenlogistikeinrichtung unter Verwendung der Logistikeinrichtung-Projekt-Datei illustriert,
- Fig. 4: eine schematische Darstellung der Warenlogistikeinrichtung, wobei eine Inbetriebnahme der Warenlogistikeinrichtung unter Verwendung der Logistikeinrichtung-Projekt-Datei illustriert ist,
- Fig. 5: eine schematische Illustration eines Betriebs der Warenlogistikeinrichtung unter Verwendung der Logistikeinrichtung-Projekt-Datei,
- Fig. 6: eine schematische Illustration einer Verwendung der Logistikeinrichtung-Projekt-Datei zur Erweiterung der Warenlogistikeinrichtung,
- Fig. 7: eine schematische Illustration eines Fernzugriffs zum Zweck der Wartung der Warenlogistikeinrichtung, auf der Grundlage der Logistikeinrichtung-Projekt-Datei,
- Fig. 8: einen beispielhaften Bildschirmausschnitt eines Steuerungsfensters einer globalen Verkehrssteuerung,
- Fig. 9: einen weiteren beispielhaften Bildschirmausschnitt, in dem Parameter einer globalen Ladesteuerung eingestellt werden können,
- Fig. 10: eine Detailansicht einer Visualisierung einer Warenlogistikeinrichtung, die einen Betriebsgefahrenbereich zeigt.

In den Zeichnungen sind jeweils gleiche oder gleichartige Elemente und/oder Teile mit denselben Bezugsziffern versehen, so dass von einer erneuten Vorstellung jeweils abgesehen wird.

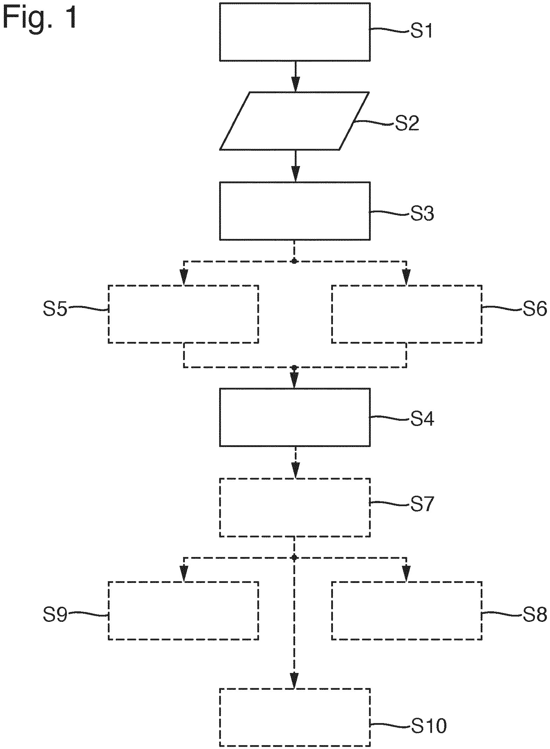

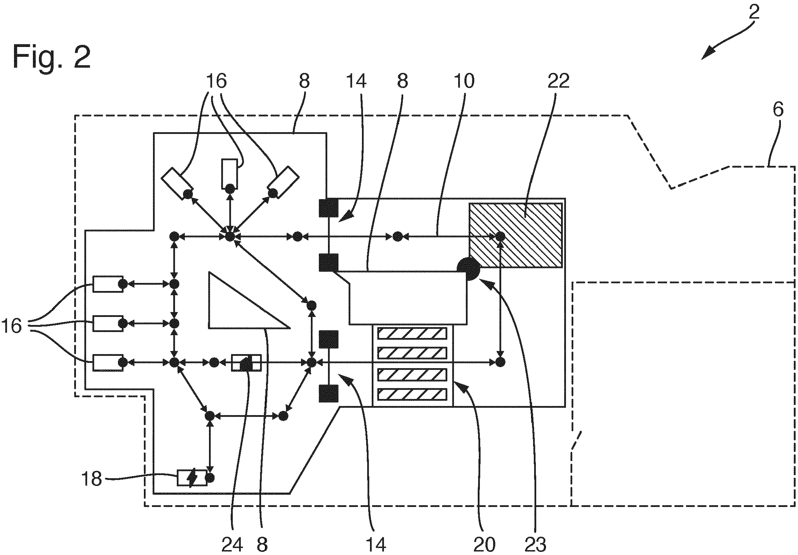

Fig. 1 zeigt ein Ablaufdiagramm, in welchem einzelne Schritte eines Verfahrens zum Anlegen einer Logistikeinrichtung 2 gezeigt sind. Eine schematisch vereinfachte Darstellung der Warenlogistikeinrichtung 2 ist in Fig. 2 gezeigt.

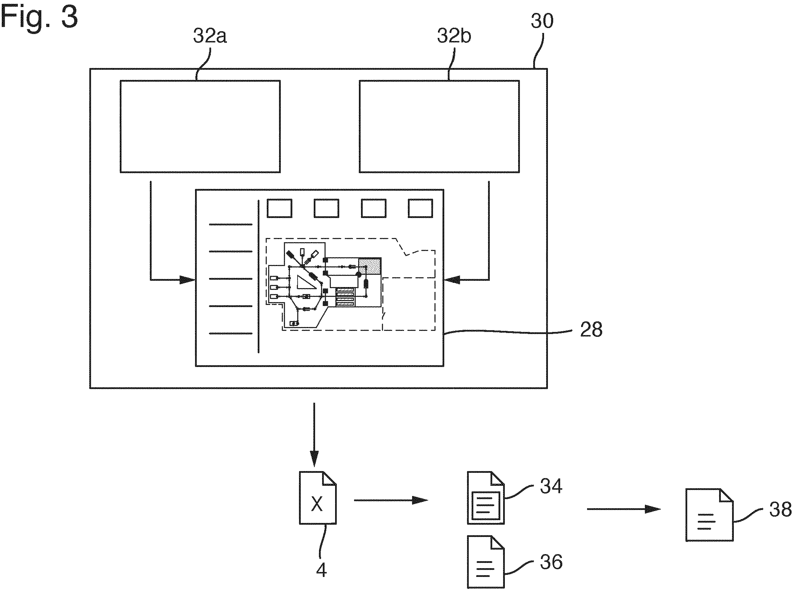

Das Verfahren beginnt mit der Erstellung (S1) einer der Warenlogistikeinrichtung 2 zugeordneten Logistikeinrichtung-Projekt-Datei 4 (vgl. auch Fig. 3). Im Folgenden soll die Logistikeinrichtung-Projekt-Datei 4 kurz auch als Projekt-Datei 4 bezeichnet werden. In die Projekt-Datei 4 werden Daten eingefügt (S2; Fig. 1), die Eigenschaften zumindest einer Komponente der Warenlogistikeinrichtung 2 beschreiben. Komponenten der Warenlogistikeinrichtung 2 sind unter anderem ein Bauwerk 6 der Warenlogistikeinrichtung 2, welches in Fig. 2 in Form eines Gebäudeumrisses in gestrichelter Linie gezeigt ist. Eine weitere Komponente der Warenlogistikeinrichtung 2 sind Fahrbereiche 8 und Transportwege 10. In der Warenlogistikeinrichtung 2, wie sie Fig. 2 zeigt, ist der Fahrbereich 8 mit dem entsprechend referenzierten Polygonzug umgeben. Zentral befinden sich weitere Grenzen des Fahrbereichs 8, wodurch Aussparungen des Fahrbereichs 8 definiert werden. Die Transportwege 10 bestehen aus mit Pfeilen dargestellten sogenannten Kanten des Transportwegs 10 und mit Punkten dargestellten Knoten des Transportwegs 10. Transportwege 10 werden vielfach auch als Fahrspur bezeichnet.

Eine weitere Komponente der Warenlogistikeinrichtung 2 sind Logistik-Infrastrukturelemente 12. Beispielhaft umfasst die Warenlogistikeinrichtung 2 als Logistik-Infrastrukturelemente 12 Rolltore 14, Ladehilfsmittel-Stationen 16 wie beispielsweise Palettenstationen, eine Ladestation 18 zum Laden von batteriebetriebenen Flurförderzeugen, einen Fußgängerüberweg 20, einen Zonenüberwachungsbereich 22 und eine Home-Station 24. Die Ladestation 18 umfasst ein Ladegerät, welches die Ladeelektronik umfasst und den zum Aufladen des Flurförderzeugs erforderlichen Strom bereitstellt. Die Ladestation 18 kann weitere elektronische, mechanische oder elektromechanische Komponenten enthalten, mit denen eine Annäherung und Kontaktierung des Flurförderzeugs gesteuert oder geregelt werden kann. Anstatt einer einzelnen Ladestation 18, wie sie beispielhaft in der Figur dargestellt ist, können ebenfalls mehrere Ladestationen 18 entsprechend angeordnet sein.

Eine weitere Komponente der Warenlogistikeinrichtung 2 sind Intralogistik-Warentransportvorrichtungen 25, bei denen es sich beispielsweise um Flurförderzeuge 26 handelt. In die Projekt-Datei 4 werden in Schritt S2 Daten eingefügt und in der Projekt-Datei 4 gespeichert, die Eigenschaften zumindest einer der genannten Komponenten der Warenlogistikeinrichtung 2 beschreiben. Konkret werden in die Projekt-Datei 4 Daten eingefügt, die konstruktive Eigenschaften des Bauwerks 6 der Warenlogistikeinrichtung 2 beschreiben, beispielsweise Abmessungen des gezeigten Grundrisses. Ferner werden in die Projekt-Datei 4 Daten eingefügt, die geometrische und/oder funktionelle Eigenschaften der Fahrbereiche 8 und/oder der Transportwege 10 in der Warenlogistikeinrichtung 2 beschreiben. Beispielsweise wird die Position der Fahrbereiche 8 und ihr Verlauf anhand eines in der Warenlogistikeinrichtung 2 etablierten Koordinatensystems beschrieben. Die Transportwege 10 können beispielsweise anhand der Positionen der mit Punkten dargestellten Knoten und der jeweils zu den umliegenden Knoten möglichen Verbindungen definiert werden. Ferner werden in die Projekt-Datei 4 Daten eingefügt, die geometrische und/oder funktionelle Eigenschaften der Logistik-Infrastrukturelemente 12 beschreiben. Beispielsweise wird die Position und Größe der Rolltore 14, Position und Lage der Ladehilfsmittel-Station 16, eine Position der Ladestation 18, eine Position und Abmessung des Fußgängerüberwegs 20, eine Position und Größe des Zonenüberwachungsbereichs 22 einschließlich der Zonenüberwachungsvorrichtung 23 und eine Position und Größe der Home-Station 24 vermerkt. Die Zonenüberwachungsvorrichtung 23 ist beispielhaft als separate Einheit dargestellt. Es kann sich bei der Zonenüberwachungsvorrichtung 23 beispielsweise um eine Sensoreinheit handeln, welche optional über eine entsprechende Auswerte Logik verfügt. Die Funktionalität der Zonenüberwachungsvorrichtung 23 kann ebenso von einem zentralen Steuerrechner bereitgestellt werden. Funktionelle Eigenschaften der Logistik-Infrastrukturelemente 12 können beispielsweise der maximal von der Ladestation 18 bereitgestellte Ladestrom oder eine Funktion der Rolltore 14 sein, beispielsweise ob diese automatisch öffnen oder mit welcher Geschwindigkeit oder innerhalb welches Zeitraums die Rolltore 14 öffnen bzw. schließen. Ferner werden in die Projekt-Datei 4 Daten eingefügt und in dieser gespeichert, die geometrische und/oder funktionelle Eigenschaften von den in der Warenlogistikeinrichtung 2 eingesetzten Intralogistik-Warentransportvorrichtungen 25, beispielsweise der zu diesem Zweck verwendeten Flurförderzeuge 26, beschreiben. Geometrische Eigenschaften sind beispielsweise die Abmessungen der Flurförderzeuge 26, funktionelle Eigenschaften können z.B. die mit den Flurförderzeugen 26 befahrbaren Kurvenradien sein. Ausgehend von diesen Informationen wird ein Planungsmodell der Warenlogistikeinrichtung 2 erstellt (S3).

Fig. 3 illustriert die Erstellung eines solchen Planungsmodells unter Verwendung einer entsprechenden Planungssoftware 28, die auf einem geeigneten Rechner 30 implementiert ist. Der Planungssoftware 28 werden zur Erzeugung der Projekt-Datei 4 die vorgenannten Daten, welche Komponenten der Warenlogistikeinrichtung 2 beschreiben, als Input zur Verfügung gestellt. Beispielhaft dargestellt ist ein erster Daten-Input 32a mit dem Daten betreffend konstruktive Eigenschaften des Bauwerks 3 der Warenlogistikeinrichtung 2 und geometrische und funktionelle Eigenschaft von Fahrbereichen 8 und Transportwegen 10 in der Warenlogistikeinrichtung 2 der Planungssoftware 28 zur Verfügung gestellt werden. Dabei werden die Fahrbereiche 8 und Transportwege 10 insbesondere auf der Basis von Hintergrundzeichnungen manuell erstellt. In einem zweiten Daten-Input 32b werden Daten beschreibend geometrische und funktionelle Eigenschaften der Logistik-Infrastrukturelemente 12 und geometrische und funktionelle Eigenschaften der eingesetzten Intralogistik-Warentransportvorrichtungen 25 eingegeben.

Als nächstes folgen in dem Ablaufdiagramm von Fig. 1 optionale Schritte, welche zu einem späteren Zeitpunkt erläutert werden sollen. Schritte, die während der Lebensdauer der Warenlogistikeinrichtung 2 durchgeführt werden können, sind in gestrichelter Linie dargestellt. Es folgt daher als nächster Schritt S4 die Realisierung der Warenlogistikeinrichtung 2 auf der Grundlage des in Schritt S3 erstellten Planungsmodells und unter Verwendung der in der Projekt-Datei 4 gespeicherten Daten. Bei den im Ablaufdiagramm von Fig. 1 in gestrichelter Linie dargestellten Schritten handelt es sich um Maßnahmen, die während des Lebenszyklus der Warenlogistikeinrichtung 2 durchgeführt werden können. Diese Maßnahmen verändern die geometrischen und/oder funktionellen Eigenschaften der Warenlogistikeinrichtung 2 oder überwachen die Warenlogistikeinrichtung 2 im Hinblick auf ihren Zustand. Die während des Lebenszyklus der Warenlogistikeinrichtung 2 durchgeführten Maßnahmen erfolgen unter Verwendung der in der Projekt-Datei 4 gespeicherten Daten. Es ist möglich, diese in gestrichelter Linie dargestellten Verfahrensschritte, welche jeweils für sich genommen eine weitere Maßnahme illustrieren, welche die Warenlogistikeinrichtung 2 im Hinblick auf ihre geometrischen und/oder funktionellen Eigenschaften verändert oder visualisiert, wiederholt oder auch iterativ durchgeführt werden. Aus Gründen der Übersichtlichkeit soll auf entsprechende Pfeile, die diese Beziehungen der weiteren Maßnahmen untereinander illustrieren, in der Darstellung verzichtet werden.

Beispielsweise wird, wie in Fig. 3 gezeigt, eine Materialliste 34 und eine Liste 36 erforderlicher Bauleistungen, die erforderlich für die Realisierung der Warenlogistikeinrichtung 2 sind, unter Verwendung der in der Projekt-Datei 4 gespeicherten Daten erstellt. Aus der Materialliste 34 und der Liste 36 der erforderlichen Bauleistungen wird wiederum eine Kostenschätzung 38 für die Realisierung der Warenlogistikeinrichtung 2 erstellt. Die Erstellung der Materialliste 34 und der Liste 36 der erforderlichen Bauleistungen und die Erstellung der Kostenschätzung 38 soll unter dem in Fig. 1 als optionalen Schritt gekennzeichneten Schritt S5 erfolgen. Typischerweise erfolgt ein solcher Schritt bevor die Warenlogistikeinrichtung 2 realisiert wird (S4). Es ist jedoch ebenso möglich, dass die Erstellung einer Materialliste 34 und einer Liste 36 der erforderlichen Bauleistungen sowie die Erstellung einer Kostenschätzung 38 im Rahmen einer Erweiterung oder eines Umbaus der Warenlogistikeinrichtung 2 (change request) vorgenommen werden. In der Planungssoftware 28 kann außerdem eine Simulation der Warenlogistikeinrichtung 2 vorgenommen werden. Eine solche Simulation des Betriebs der Warenlogistikeinrichtung 2 soll als optionaler Schritt S6 in Fig. 1 bezeichnet werden. Die Schritte S5 und S6 können, wie in der Fig. dargestellt, parallel oder auch nacheinander durchgeführt werden, wobei die Reihenfolge nicht festgelegt ist. Typischerweise wird auch der Schritt (S6), also eine Simulation, durchgeführt, bevor die Warenlogistikeinrichtung 2 realisiert wird (S4). Die Simulation der Warenlogistikeinrichtung 2 erfolgt in dem Planungsmodell der Warenlogistikeinrichtung 2. Dieses Planungsmodell kann basierend auf den Ergebnissen der Simulation optimiert werden. Dementsprechend werden die in der Projekt-Datei 4 vorhandenen Daten anhand des Ergebnisses dieser Optimierung aktualisiert. Es wird anschließend ein finalisiertes Planungsmodell der Warenlogistikeinrichtung 2 erstellt. Die Modelldaten des finalisierten Planungsmodells werden in der Projekt-Datei 4 gespeichert.

Wie bereits weiter oben erwähnt ist es beispielsweise möglich eine Iteration der Schritte S5 und der Schritte S6 vorzunehmen. Mit anderen Worten kann also beispielsweise iterativ nacheinander jeweils eine Materialliste 34 erstellt werden (Schritt S5), auf dessen Grundlage beispielsweise auch eine Kostenschätzung erstellt werden kann, und anschließend wird (Schritt S6) eine Simulation der Warenlogistikeinrichtung 2 vorgenommen. Auf der Grundlage des Ergebnisses der Simulation kann das Layout der Warenlogistikeinrichtung 2 angepasst werden. Ein verändertes Layout bedeutet beispielsweise eine Reduzierung der Anzahl von Flurförderzeugen, was dann wiederum zu einer Veränderung der Materialliste 34 führt usw.

Im Rahmen der Modellierung werden insbesondere in der Projekt-Datei 4 umfasste Daten berücksichtigt, welche die Geometrie der zu befahrenden Transportwege 10 und geometrische Daten zu den Logistik-Infrastrukturelementen 12, die mit den Intralogistik-Warentransportvorrichtungen 25 zusammenwirken, beschreiben. Logistik-Infrastrukturelemente 12, welche im Rahmen der Simulation der Warenlogistikeinrichtung 2 berücksichtigt werden, sind beispielsweise Ladehilfsmittel-Stationen 16 als Warenübergabestationen, Ladestationen 18, Parkpositionen, Abstellplätze und/oder Lagerplätze. Der Schritt der Simulation schließt insbesondere eine Simulation des Betriebs der Warenlogistikeinrichtung 2 ein, indem eine Validierung der zu befahrenden Transportwege 10 durchgeführt wird. Bei der Validierung der zu befahrenden Transportwege 10 wird überprüft, ob ein insbesondere vollständiger durchgehend befahrbarer Fahrspurengraph, wie ihn beispielsweise die Darstellung in Fig. 2 zeigt, erstellt werden kann. Dieser Fahrspurengraph soll nach Möglichkeit alle Logistik-Infrastrukturelemente 12 miteinander verbinden bzw. schneiden. Handelt es sich bei dem Logistik-Infrastrukturelement 12 beispielsweise um eine Ladestation 18, so müsste der Fahrspuren-Graph mit dieser verbunden werden. Handelt es sich hingegen bei dem Logistik-Infrastrukturelement 12 um ein Tor, so müsste dieser das entsprechende Element schneiden.

Außerdem kann im Rahmen der Simulation ermittelt werden, ob die Vorgaben für die zu realisierende Warenlogistikeinrichtung 2 im Hinblick auf den geplanten Warendurchsatz erfüllt werden. Entsprechend des Ergebnisses der Simulation kann dann beispielsweise die Anzahl und/oder der Typ der eingesetzten Warentransportvorrichtungen, beispielsweise der benötigten Flurförderzeuge 26, die Anordnung der Transportwege und/oder die Anordnung und/oder der Typ der verwendeten Logistik-Infrastrukturelemente 12 angepasst werden.

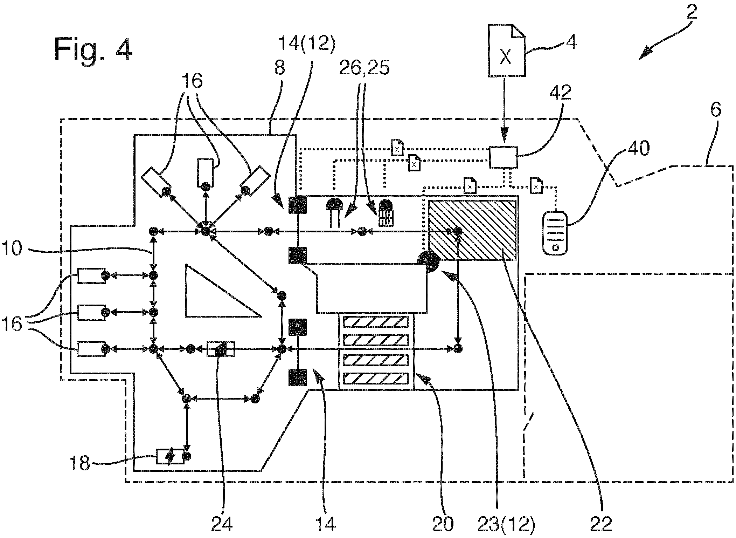

Fig. 4 zeigt die bereits aus Fig. 2 bekannte schematische Darstellung der Warenlogistikeinrichtung 2. Bereits im Zusammenhang mit Fig. 2 erläuterte identisch dargestellte Elemente der Warenlogistikeinrichtung 2 sollen nicht nochmalig erläutert werden. Die Aufnahme des Betriebs ist in Fig. 1 mit dem optional dargestellten Verfahrensschritt S7 illustriert. Die Aufnahme des Betriebs der Warenlogistikeinrichtung 2 erfolgt unter Verwendung der in der Projekt-Datei 4 gespeicherten Daten. Es wird eine Konfiguration von Logistik-Infrastrukturelementen 12 und von Intralogistik-Warentransportvorrichtungen 25 vorgenommen, hierbei kann es sich insbesondere um autonome oder automatisch geführte Intralogistik-Warentransportvorrichtungen 25 handeln. Als Logistik-Infrastrukturelemente 12 werden mit Hilfe von in der Projekt-Datei 4 gespeicherten Daten oder aus dieser extrahierten Daten beispielhaft das Rolltor 14 und die Zonenüberwachungsvorrichtung 23 konfiguriert und eingelernt. Beispielsweise kann in diesem Zusammenhang der von der Zonenüberwachungsvorrichtung 23 aufgespannte Zonenüberwachungsbereich 22 seiner Größe und Position nach den in der Projekt-Datei 4 gespeicherten Daten entnommen werden. Ferner werden mit Hilfe von in der Projekt-Datei 4 gespeicherten oder aus dieser extrahierten Daten die Flurförderzeuge 26 sowie das mobile Endgerät 40 konfiguriert und angelernt oder es wird dem mobilen Endgerät 40 Zugriff auf die Projekt-Datei 4 oder auf aus dieser abgeleitete Daten gewährt. Konkret kann die Anwendung am Steuerrechner für die geführte Inbetriebsetzung auf der Basis der Projekt-Datei 4 konfiguriert sein. Ein mobiler Techniker-Arbeitsplatz ruft beispielsweise bei der schrittweisen Inbetriebnahme eine Applikation auf, beispielsweise eine Web-Anwendung oder dergleichen. Diese wiederum greift auf die Daten der Logistikeinrichtung-Projekt-Datei 4 zu oder auf aus dieser abgeleitete Daten, wobei die Projekt-Datei 4 nach wie vor von einem Steuerrechner 42 gehostet wird. Das mobile Endgerät 40 dient auf diese Weise beispielsweise der geführten Inbetriebsetzung. Für diesen Vorgang, d.h. des Aufnehmens (S7) eines Betriebs der Warenlogistikeinrichtung 2 wird die Projekt-Datei 4 beispielsweise auf einen Steuerrechner 42 der Warenlogistikeinrichtung 2 übertragen. Die Kommunikation der Daten, dargestellt in Fig. 4 mit punktierter Linie, erfolgt über geeignete Datenverbindungen, dies können drahtgebundene oder drahtlose Datenverbindungen sein.

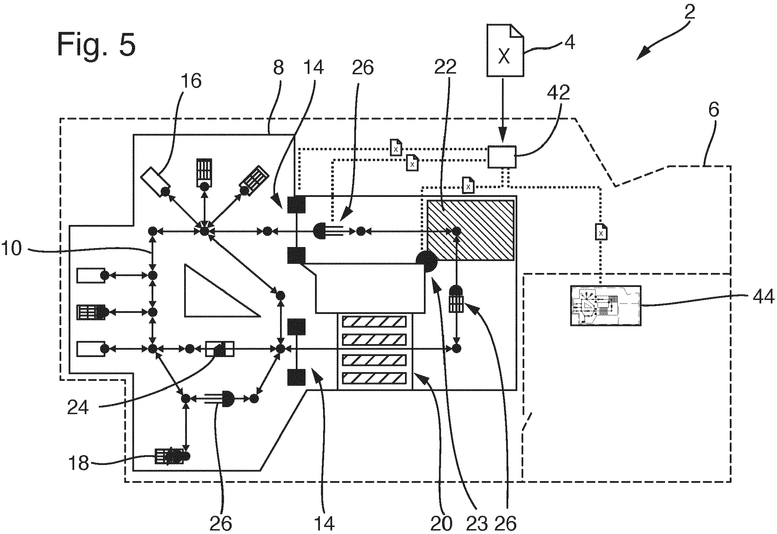

Nach der Inbetriebnahme kann die Steuerung der Warenlogistikeinrichtung 2 auf der Grundlage der in der Projekt-Datei 4 gespeicherten Daten erfolgen. Die Steuerung des laufenden Betriebs ist in dem Ablaufdiagramm von Fig. 1 ebenfalls im Schritt S7 zusammengefasst, Fig. 5 zeigt diese Steuerung. Die Darstellung in Fig. 5 entspricht derjenigen von Fig. 4, es sollen lediglich abweichende Elemente ausdrücklich erwähnt und beschrieben werden.

Die in Fig. 5 illustrierte Steuerung des Betriebs der Warenlogistikeinrichtung 2 erfolgt durch den Steuerrechner 42, der mit einem Fahrzeugleitstand 44 verbunden ist. Wiederum ist eine geeignete Datenverbindung über eine punktierte Linie illustriert, es kann sich um eine drahtgebundene oder drahtlose Datenverbindung handeln. Zur Steuerung des Betriebs steht der Steuerrechner 42 beispielhaft in Datenverbindung mit dem Rolltor 14, einem Flurförderzeug 26 und der Zonenüberwachungsvorrichtung 23. Wie bereits weiter oben erwähnt, kann es sich bei der Zonenüberwachungsvorrichtung 23 um einen Sensor oder dergleichen handeln, während die eigentliche Funktionalität der Zonenüberwachung von dem Steuerrechner 42 bereitgestellt wird. Alternativ kann der Steuerrechner 42 die Funktion einer Zonenüberwachung übernehmen, insofern die Positionen der Flurförderzeuge 26 bekannt sind. Die Positionen der Flurförderzeuge 26 können beispielsweise mittels Sensoren an den Fahrzeugen erfasst und zyklisch an den Steuerrechner 42 übermittelt werden. Es ist somit gemäß einem weiteren Ausführungsbeispiel nicht notwendig, dass die Zonenüberwachungsvorrichtung 23 einen Sensor umfasst. Abweichend von der Darstellung von Fig. 4 befinden sich in Fig. 5 drei Flurförderzeuge auf den Ladehilfsmittel-Stationen 16, von denen aus Gründen der Übersichtlichkeit lediglich eine mit Bezugszeichen versehen ist. Bei den Ladehilfsmitteln handelt es sich beispielsweise um Paletten, sodass es sich bei den Ladehilfsmittel-Stationen beispielsweise um Palettenstationen handeln kann. Außerdem wird ein Flurförderzeug 26 an der Ladestation 18 aufgeladen. Während zwei der in Fahrt befindlichen Flurförderzeuge 26 leer dargestellt sind, ist das rechts in der Nähe des Zonenüberwachungsbereichs 22 dargestellte Flurförderzeug 26 beladen dargestellt. Die Steuerung des laufenden Betriebs der Warenlogistikeinrichtung 2 umfasst insbesondere eine Steuerung der Logistik-Infrastrukturelemente 12 sowie der Intralogistik-Warentransportvorrichtungen 25. Zu diesem Zweck ist auf dem Steuerrechner 42 zur Steuerung der Warenlogistikeinrichtung 2 die Projekt-Datei 4 oder aus dieser extrahierte Daten vorhanden.

Zur Steuerung der Warenlogistikeinrichtung 2 ist es vorteilhaft, wenn diese, wie an dem Fahrzeugleitstand 44 angedeutet, visualisiert wird. Eine Visualisierung ist als optionaler Verfahrensschritt S8 in Fig. 1 dargestellt. Die Visualisierung der Warenlogistikeinrichtung 2 im Betrieb erfolgt unter Verwendung der in der Projekt-Datei 4 vorhandenen Daten. Die Visualisierung erfolgt als grafische Darstellung, wobei beispielsweise der Grundriss des Bauwerks 6 dargestellt wird. Bei der Visualisierung kann eine Geometrie des Bauwerks 6 berücksichtigt werden. Ferner umfasst die Visualisierung, ähnlich wie es die Fig. 2 bis 7 zeigen, eine grafische Darstellung der Logistik-Infrastrukturelemente 12. Auch hier können Abmessungen und Größenverhältnisse bei der Visualisierung berücksichtigt werden. Ferner umfasst die Visualisierung eine grafische Darstellung der Intralogistik-Warentransportvorrichtungen 25, beispielsweise der eingesetzten Flurförderzeuge. Auch hier können wiederum Größenverhältnisse und Abmessungen bei der Visualisierung berücksichtigt werden. Ferner können in der Visualisierung funktionelle Eigenschaften sowohl bei den Logistik-Infrastrukturelementen 12 als auch bei den Intralogistik-Warentransportvorrichtungen 25 berücksichtigt werden. Beispielsweise zeigt die Illustration, wie sie in den Fig. 2 bis 7 gezeigt ist, an, ob ein Flurförderzeug 26 als beispielhafte Intralogistik-Warentransportvorrichtung 25 beladen ist oder nicht. Ferner wird eine aktuelle Position und ein Status, beispielsweise beladen oder unbeladen, der Intralogistik-Warentransportvorrichtungen 25 angezeigt. Es kann beispielsweise angezeigt werden, in welchem Segment zwischen welchen Wegpunkten sich ein Flurförderzeug 26 aktuell befindet. Auch kann ein Betriebsstatus angezeigt werden, beispielsweise ob eine Störung vorliegt, oder beispielsweise das Flurförderzeug 26 einen niedrigen Akkustand aufweist. Die Visualisierung erfolgt beispielsweise an dem Fahrzeugleitstand 44 oder auch auf einem externen Rechner. Zu dem letzteren Zweck gestattet der Steuerrechner 42 dem externen Rechner Zugriff auf die Projekt-Datei 4. Beispielsweise wird die Visualisierung auf dem Steuerrechner 42 als Web-Anwendung bereitgestellt. Der externe Rechner greift über einen Browser auf diese von dem Steuerrechner 42 bereitgestellte Web-Anwendung zu. Zu diesem Zweck sind in der Projekt-Datei 4 gespeicherte Daten, aus dieser abgeleitete Daten oder aus dieser extrahierte Daten in dem Fahrzeugleitstand 44 hinterlegt oder können über die dargestellte Datenverbindung zwischen dem Fahrzeugleitstand 44 und dem Steuerrechner 42 an den Fahrzeugleitstand 44 übermittelt werden. Gleiches gilt für einen externen Rechner.

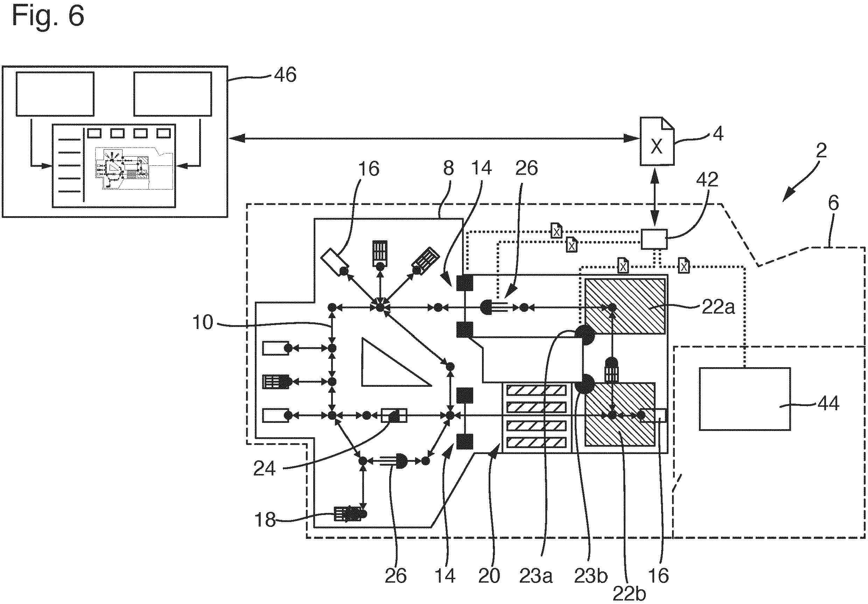

Fig. 6 zeigt die Warenlogistikeinrichtung 2, welche im Vergleich zu der aus Fig. 5 bekannten Warenlogistikeinrichtung 2 erweitert wurde. Es ist eine zweite Zonenüberwachungsvorrichtung 23b hinzugefügt worden, welche einen zweiten Zonenüberwachungsbereich 22b aufspannt. Die bisherige Zonenüberwachungsvorrichtung ist nun eine erste Zonenüberwachungsvorrichtung 23a, die einen ersten Zonenüberwachungsbereich 22a aufspannt. Teilweise innerhalb dieses zweiten Zonenüberwachungsbereichs 22b befindet sich außerdem eine weitere Ladehilfsmittel-Station 16. Zur Erweiterung oder Änderung der Warenlogistikeinrichtung 2 gestattet der Steuerrechner 42 dem externen Rechner 46 Zugriff auf die Projekt-Datei 4. So kann eine Erweiterung oder Änderung der Warenlogistikeinrichtung 2 mit Hilfe des externen Rechners 46 ähnlich der im Zusammenhang mit Fig. 2 durchgeführten Planung, jedoch lediglich für die zu erweiternden Elemente, erfolgen, wobei anschließend eine Anpassung in der Projekt-Datei 4 vorgenommen wird, so dass diese nun auch die im Rahmen der Änderung hinzugefügten Daten umfasst. Diese Änderung umfasst beispielsweise eine Anpassung von geometrischen Daten, beschreibend das Bauwerk 6, eine Anpassung von geometrischen und/oder funktionellen Eigenschaften von Logistik-Infrastrukturelementen 12, den Austausch oder die Ergänzung von Intralogistik-Warentransportvorrichtungen 25 oder eine Änderung eines Typs der eingesetzten Intralogistik-Warentransportvorrichtungen 25, beispielsweise eines neueren Typs Flurförderzeug 26. Ferner umfasst die Änderung beispielsweise den Austausch oder die Ergänzung von Logistik-Infrastrukturelementen 12, wie beispielsweise eines Rolltors 14 oder eben die Hinzufügung der zweiten Zonenüberwachungsvorrichtung 23b unter Aufnahme des zweiten Zonenüberwachungsbereichs 22b in die Struktur der Warenlogistikeinrichtung 2. Hieraus kann sich auch eine Veränderung der erlaubten Fahrbereiche 8 oder Transportwege 10 ergeben.

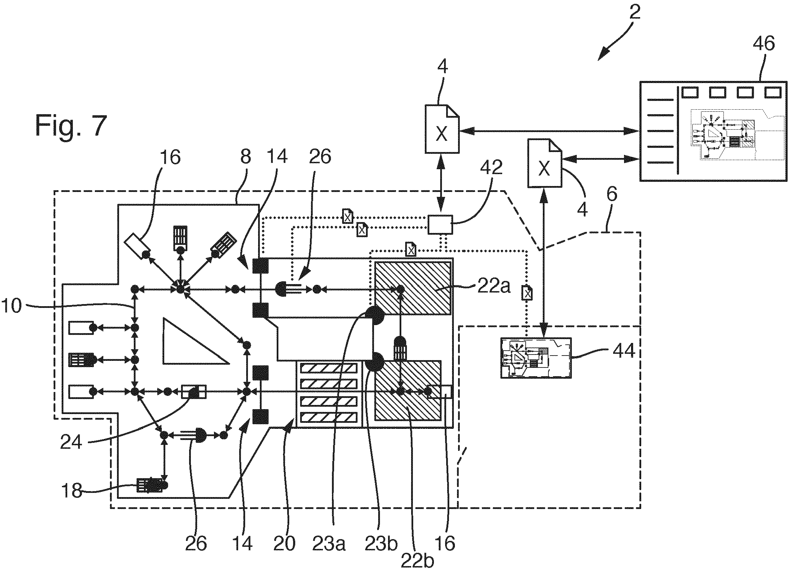

Fig. 7 zeigt eine schematische Illustration der bereits aus Fig. 6 bekannten Warenlogistikeinrichtung 2, also einschließlich der durchgeführten Erweiterung. Der externe Rechner 46 dient in diesem Fall nicht der Planung einer Erweiterung der Warenlogistikeinrichtung 2, sondern der Durchführung einer Fernwartung. Während die Erweiterung in dem Ablaufdiagramm von Fig. 1 mit Schritt S9 bezeichnet werden soll, wird die Durchführung einer Fernwartung mit Schritt S10 bezeichnet. Die Schritte S8, S9 und S10 stehen gleichwertig in dem Ablaufdiagramm, es ist keine spezielle Reihenfolge der Durchführung dieser Schritte vorgesehen.

Bei der Durchführung einer Fernwartung gewährt der Steuerrechner 42 dem externen Rechner 46 Zugriff auf die Projekt-Datei 4. Beispielsweise ist die Logistikeinrichtung-Projekt-Datei 4 auf dem Steuerrechner 42 gespeichert. Jeder weitere Rechner, der Zugriff auf den Steuerrechner 42 bzw. auf die von diesem bereitgestellten Dienste hat, kann diese Projekt-Datei 4 anfordern, was eine vorherige erfolgreiche Authentifizierung des weiteren Rechners voraussetzt. Sollte sich die Projekt-Datei 4 im Fahrzeugleitstand 44 gespeichert befinden, so kann ebenso der Fahrzeugleitstand 44 dazu eingerichtet sein, im externen Rechner 46 Zugriff auf die Projekt-Datei 4 zu gewähren. Die Durchführung einer Fernwartung umfasst insbesondere die Visualisierung der Warenlogistikeinrichtung 2 an dem externen Rechner 46. Die detaillierte Visualisierung einschließlich der Funktionalitäten erlaubt eine umfassende Analyse des Zustands der Warenlogistikeinrichtung 2 und somit die Durchführung einer Ferndiagnose.

Bei der Durchführung einer Maßnahme, welche die Warenlogistikeinrichtung 2 im Hinblick auf ihre konstruktiven, geometrischen und/oder funktionellen Eigenschaften beeinflusst oder einen Zustand der Warenlogistikeinrichtung 2 überwacht, und welches während des Lebenszyklus der Warenlogistikeinrichtung 2 durchgeführt wird, werden Daten aus der Logistikeinrichtung-Projekt-Datei 4 ausgelesen oder Daten aus den in dieser Datei gespeicherten Daten abgeleitet. Diese Daten werden zwischen einzelnen Einheiten der Warenlogistikeinrichtung 2 übertragen.

Die aus der Logistikeinrichtung-Projekt-Datei 4 entnommenen Daten (wobei auch von diesen abgeleitete Daten gemeint sind, ohne dass dies im Folgenden wiederholt explizit erwähnt werden soll) können beispielsweise auf Logistik-Infrastrukturelemente 12 und/oder auf Intralogistik-Warentransportvorrichtungen 25 übertragen werden. Alternativ kann die Konfiguration, d.h. die aus der Logistikeinrichtung-Projekt-Datei 4 entnommenen Daten der Logistik-Infrastrukturelemente 12 wie Tore und dergleichen, die bei der Ansteuerung berücksichtigt werden müssen, auch durch den Steuerrechner berücksichtigt werden. In diesem Fall werden die Daten also bei deren Steuerung berücksichtigt, indem die entsprechende Logik über den Steuerrechner 42 abgebildet wird. Eine solche Datenübertragung kann zu verschiedenen Zwecken vorgenommen werden. Die Datenübertragung erfolgt im Rahmen der Durchführung der oben beschriebenen weiteren Maßnahme.

Beispielsweise können in der Logistikeinrichtung-Projekt-Datei 4 die in der Warenlogistikeinrichtung 2 zum Einsatz kommenden Stelltypen der Ladehilfsmittel definiert werden. Beispielsweise wird festgelegt, dass in der Warenlogistikeinrichtung 2 Europaletten, Industriepaletten und Rollcontainer verwendet werden. Diese Stelltypen inklusive der zugehörigen Abmessungen werden bei der Übertragung des Projekts, also beispielsweise bei der Inbetriebnahme der Warenlogistikeinrichtung 2, oder während der Steuerung des Betriebs der Warenlogistikeinrichtung 2 aus der Logistikeinrichtung-Projekt-Datei 4 von dem Steuerrechner 42 ausgelesen. Die Daten können in transformierter Version verwaltet und bei der Ausführung, also bei der Steuerung des laufenden Betriebs der Warenlogistikeinrichtung 2, berücksichtigt oder verwendet werden.

Der Stelltyp des Ladehilfsmittels kann außerdem während der Steuerung des laufenden Betriebs der Warenlogistikeinrichtung 2 von dem Steuerungssystem, d.h. von dem Steuerrechner 42, der den laufenden Betrieb der Warenlogistikeinrichtung 2 steuert, berücksichtigt werden. Beispielsweise kann der Ablauf eines Warentransports unter Berücksichtigung des verwendeten Ladehilfsmittels berechnet und geplant werden.

Der Stelltyp kann außerdem an eine Intralogistik-Warentransportvorrichtung 25, beispielsweise an ein Flurförderzeug, bei Übergabe eines Transportauftrags mitgeteilt werden, d.h. von dem Steuerrechner 42 auf die Intralogistik-Warentransportvorrichtung 25 übertragen werden. So wird das Flurförderzeug in die Lage versetzt, das Ladehilfsmittel entsprechend seinem Typ passend aufzunehmen. Unterschiedliche Stelltypen erfordern nämlich eine unterschiedliche Aufnahme bzw. Anfahrt für die Aufnahme durch das Flurförderzeug. Außerdem kann ggf. der Transportweg unter Berücksichtigung der Größe des verwendeten Lasthilfsmittels geplant und durchgeführt werden. Alternativ kann dies auch als generell gültige Konfigurationsinformation an das Fahrzeug übertragen werden, wenn beispielsweise nur ein einziger Stelltyp verwendet wird.

Ferner beispielsweise können in der Logistikeinrichtung-Projekt-Datei 4 Daten betreffend ein Layout der Fahrbereiche gespeichert sein, also Daten, die Lage und/oder Abmessungen der Fahrbereiche beschreiben. Während einer weiteren Maßnahme werden diese Daten aus der Logistikeinrichtung-Projekt-Datei 4 ausgelesen, beispielsweise bei der Inbetriebnahme der Warenlogistikeinrichtung 2. Die Daten können in transformierter Version verwaltet und bei der Ausführung, also bei der Steuerung des laufenden Betriebs der Warenlogistikeinrichtung 2, berücksichtigt oder verwendet werden.

Ein Fahrbereich wird beispielsweise während der Planung erstellt und anschließend in der Simulation validiert. Die Ergebnisse der Simulation können dann wieder in eine Anpassung münden, die zu einer Optimierung der Warenlogistikeinrichtung 2 führt. Die zugehörigen Daten werden in der Warenlogistikeinrichtung-Projekt-Datei 4 abgelegt. Ferner kann das Layout der Fahrbereiche bzw. die diesem Layout zugrundeliegenden Daten, welche in der Logistikeinrichtung-Projekt-Datei 4 abgelegt sind, auch an eine Intralogistik-Warentransportvorrichtung 25, beispielsweise an ein Flurförderzeug, übertragen werden. Somit wird die Intralogistik-Warentransportvorrichtung 25 in die Lage versetzt zu entscheiden, in welchem Bereich innerhalb der Warenlogistikeinrichtung 2 sie sich bewegen kann, und wo und in welchem Umfang Sicherheitsabstände, beispielsweise zu festen Objekten, eingehalten werden müssen. Auch die Sicherheitsabstände können in ein solches Layout integriert sein.

Gemäß einem weiteren Beispiel können in der Logistikeinrichtung-Projekt-Datei 4 Daten betreffend die globale Verkehrssteuerung innerhalb der Warenlogistikeinrichtung 2 gespeichert sein.

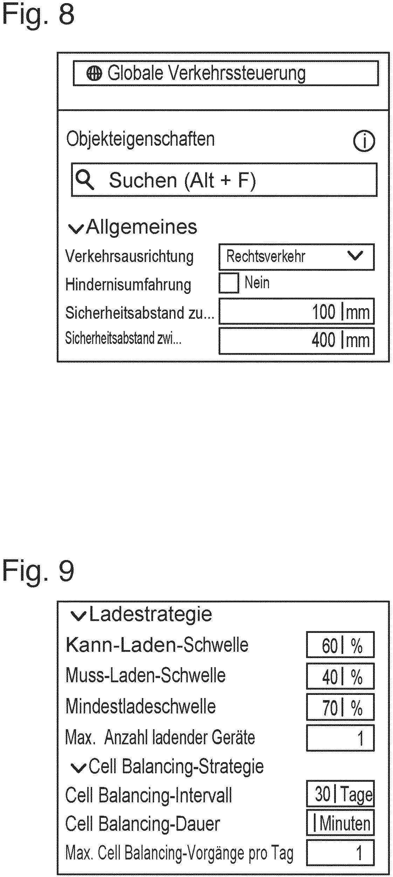

Fig. 8 zeigt beispielhaft ein Bildschirmfenster dieser globalen Verkehrssteuerung, wie es beispielsweise während einer Planung der Warenlogistikeinrichtung 2 auf einer Anzeige des Rechners 30, auf dem die Planungssoftware läuft, angezeigt wird. Die Einstellungen werden vorab in der Planungssoftware vorgenommen und anschließend im laufenden Betrieb berücksichtigt. Es ist jedoch auch möglich, sich die Einstellungen im laufenden Betrieb anzeigen zu lassen. Beispielsweise wird anhand der in der Warenlogistikeinrichtung-Projekt-Datei 4 gespeicherten Daten festgelegt, dass die allgemeine Verkehrsausrichtung innerhalb der Warenlogistikeinrichtung 2 "Rechtsverkehr" ist. Eine Hindernisumfahrung kann durch Auswahl des entsprechenden Feldes unterbunden werden. Ein beispielhafter Sicherheitsabstand von 100 mm wird zu stehenden Objekten eingehalten. Dieser Abstand kann ebenso 500 mm betragen. Der Sicherheitsabstand zu sich bewegenden Objekten beträgt 400 mm.

Alle diese Regeln und Daten können in der Logistikeinrichtung-Projekt-Datei 4 gespeichert sein und beispielsweise bei der Inbetriebnahme der Warenlogistikeinrichtung 2 oder während der Durchführung einer Steuerung des laufenden Betriebs der Warenlogistikeinrichtung 2 von dem Steuerrechner 42 aus der Projekt-Datei 4 ausgelesen werden. Die Daten können ebenso in transformierter Form verwaltet und bei der Ausführung, also bei der Steuerung des laufenden Betriebs der Warenlogistikeinrichtung 2, berücksichtigt oder verwendet werden.

Die globalen Verkehrssteuerungsregeln können ferner beispielsweise bei der Inbetriebnahme einer Intralogistik-Warentransportvorrichtung 25 von dem Steuerrechner 42 auf eine Intralogistik-Warentransportvorrichtung 25, beispielsweise ein Flurförderzeug, übertragen werden. Die Intralogistik-Warentransportvorrichtung 25 wird sich dann entsprechend der globalen Verkehrssteuerungsregeln in der Warenlogistikeinrichtung 2 verhalten, beispielsweise den allgemeinen Rechtsverkehr und die geforderten Sicherheitsabstände zu stehenden und bewegten Hindernissen einhalten.

Weitere Daten, die aus der Warenlogistikeinrichtung-Projekt-Datei 4 ausgelesen oder aus den in dieser Datei gespeicherten Daten abgeleitet werden können, betreffen die globale Ladestrategie, beispielsweise für batteriebetriebene Intralogistik-Warentransportvorrichtungen 25, wie beispielsweise elektrisch angetriebene Flurförderzeuge.

Fig. 9 zeigt wiederum einen Bildschirmausschnitt, in dem ein Steuerungsfenster gezeigt ist. Das Steuerungsfenster kann beispielsweise auf einer Anzeige des Steuerrechners 42 während einer Steuerung des laufenden Betriebs der Warenlogistikeinrichtung 2 angezeigt werden. Auch diese Einstellungen werden jedoch üblicherweise vorab in der Planungssoftware vorgenommen und anschließend im laufenden Betrieb berücksichtigt.

Gemäß einem weiteren Beispiel können in der Logistikeinrichtung-Projekt-Datei 4 Daten betreffend eine globale Ladestrategie für in der Logistikeinrichtung vorhandene Intralogistik-Warentransportvorrichtungen 25, insbesondere batteriebetriebene Flurförderzeuge, gespeichert sein.

Es werden für elektrisch betriebene Flurförderzeuge 26 verschiedene Ladeschwellen vorgegeben. Ab einer Kann-Ladeschwelle, die 60 % der maximalen Batterieladung beträgt, kann das Flurförderzeug 26 beispielsweise die Traktionsbatterie aufladen. Beispielsweise erstellt der Steuerrechner 42 für das konkrete Flurförderzeug 26 einen "Ladeauftrag", so dass das Flurförderzeug 26 die Ladestation 18 anfährt. Dementsprechend werden für dieses Flurförderzeug 26 keine Transportaufträge geplant. Ab der Muss-Ladeschwelle, die 40 % beträgt, ist es für das Flurförderzeug 26 erforderlich, eine Ladestation 18 anzufahren. Die festgelegte Mindestladeschwelle von 70 % definiert den Ladezustand, bis zu dem das Flurförderzeug in jedem Fall an der Ladestation 18 verbleiben muss, bevor es den Betrieb wieder aufnimmt.

Es ist ferner festgelegt, dass maximal ein Flurförderzeug 26 an einer Ladestation 18 geladen wird. Dies besagt der Parameter "maximale Anzahl ladender Geräte". Diese Anzahl wird beispielsweise so gewählt, dass der Betrieb nicht durch zu viele gleichzeitig im Ladevorgang befindliche Flurförderzeuge 26 beeinträchtigt wird. Ferner wird noch die Cell-Balancing-Strategie, beispielsweise für die Traktionsbatterie, festgelegt. Beispielhaft wird alle 30 Tage ein Cell-Balancing vorgenommen, was durch den Wert des Parameters "Cell-Balancing-Intervall" festgelegt ist. Es wird außerdem festgelegt, dass maximal ein Gerät und somit beispielsweise ein einziges Flurförderzeug 26 pro Tag einen Cell-Balancing-Vorgang durchführen kann. Auch an dieser Stelle geht es darum, dass nicht gleichzeitig bzw. an einem Tag alle Flurförderzeuge 26 für den Zeitraum des Cell-Balancing Vorgangs entfallen. Es handelt sich um eine globale Einstellung, die nicht für die Ladestation 18 spezifisch ist.

All die oben genannten Parameter können in der Logistikeinrichtung-Projekt-Datei 4 gespeichert sein und beispielsweise während der Inbetriebnahme oder während der Steuerung des laufenden Betriebs der Warenlogistikeinrichtung 2 von dem Steuerrechner 42 ausgelesen werden. Der Steuerrechner 42 berücksichtigt diese Vorgaben in Bezug auf das Ladeverhalten der in der Warenlogistikeinrichtung 2 vorhandenen elektrisch betriebenen Flurförderzeuge. Außerdem kann der Ladezustand der Flurförderzeuge im Hinblick auf die oben genannte globale Ladestrategie für die Erteilung entsprechender Lade- und Transportaufträge berücksichtigt werden. So können beispielsweise Ladeaufträge an Flurförderzeuge derart vergeben werden, dass die Aufladevorgänge, beispielsweise der Traktionsbatterie, zwischen zwei Transportaufträgen eingetaktet werden.

Gemäß einem weiteren Beispiel können in der Logistikeinrichtung-Projekt-Datei 4 Daten betreffend das Layout eines Betriebsgefahrenbereichs gespeichert sein, also beispielsweise dessen Lage und Abmessungen.

Als Betriebsgefahrenbereiche werden üblicherweise diejenigen Bereiche bezeichnet, die für Fußgänger beim Betreten eine Gefahr darstellen. Diese Gefahr entsteht beispielsweise dadurch, dass ein Flurförderzeug, zum Beispiel zur Stationseinfahrt, die Schutzfelder deaktivieren oder verringern muss. In diesem Zustand kann das Flurförderzeug eine Person nicht mehr erkennen und kann daher auch nicht automatisch stoppen. Es ist die Möglichkeit vorgesehen, derartige Bereiche beispielsweise bei Planung, Simulation und Optimierung der Warenlogistikeinrichtung 2 mit zu berücksichtigen. Die die Betriebsgefahrenbereiche beschreibenden Daten werden in die Warenlogistikeinrichtung-Projekt-Datei 4 integriert.

Betriebsgefahrenbereiche haben zunächst keine direkten Auswirkungen auf die Steuerung des laufenden Betriebs der Warenlogistikeinrichtung, das Verhalten der in der Warenlogistikeinrichtung vorhandenen Intralogistik-Warentransportvorrichtungen, insbesondere von Flurförderzeugen, die Durchführung von Transportaufträgen und dergleichen, also allgemein die Navigation von Intralogistik-Warentransportvorrichtungen 25 in der Warenlogistikeinrichtung 2. Ihnen kommt jedoch bei der Visualisierung und Optimierung der Warenlogistikeinrichtung 2 eine Bedeutung zu.

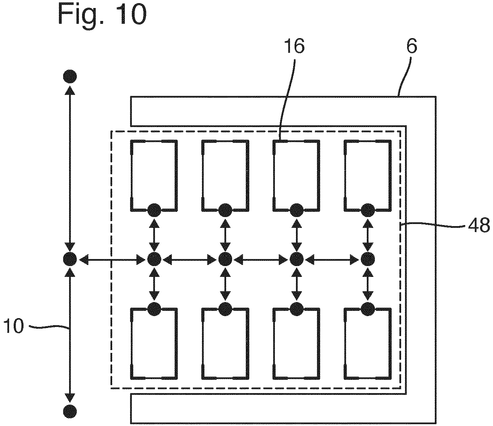

Fig. 10 zeigt eine Detailansicht einer Visualisierung einer Warenlogistikeinrichtung 2, wobei ein Betriebsgefahrenbereich 48 innerhalb eines Gebäudes 6 gezeigt ist. In dem Betriebsgefahrenbereich 48 befinden sich mehrere Ladehilfsmittelstationen 16, beispielsweise Palettenstationen. Ebenfalls gezeigt ist der zugehörige Fahrspuren-Graph 10. In den Ladehilfsmittelstationen 16 findet beispielsweise eine Palettenaufnahme statt. In dem Moment, in dem ein Flurförderzeug eine Palette aufnimmt, muss es selbstredend seine Schutzfelder zumindest in Richtung des Ladeaufnahmemittels abschalten oder verringern, da anderenfalls die entsprechenden Schutzfelder die Einfahrt des Lastaufnahmemittels, beispielsweise einer Lastgabel, in die Palette verhindern würden. Insofern besteht in dem Betriebsgefahrenbereich 48 für Fußgänger eine erhöhte Gefahr, da die Flurförderzeuge mit abgeschalteten Schutzfeldern betrieben werden.

Die Betriebsgefahrenbereiche 48 haben auf die unmittelbare Betriebssteuerung der Warenlogistikeinrichtung 2 zunächst keinen direkten Einfluss. Bei einer Visualisierung der Warenlogistikeinrichtung 2 können diese jedoch von großer Bedeutung sein, denn es liegt in der Aufgabe des Betreibers der Warenlogistikeinrichtung 2 an Ort und Stelle, beispielsweise entsprechende Bodenmarkierungen vorzunehmen und die Mitarbeiter entsprechend zu schulen, um ggf. vorhandenen Gefahren vorzubeugen.

Alle genannten Merkmale, auch die den Zeichnungen allein zu entnehmenden sowie auch einzelne Merkmale, die in Kombination mit anderen Merkmalen offenbart sind, werden allein und in Kombination als erfindungswesentlich angesehen. Erfindungsgemäße Ausführungsformen können durch einzelne Merkmale oder eine Kombination mehrerer Merkmale erfüllt sein.

### Bezugszeichenliste

- 2: Warenlogistikeinrichtung
- 4: Logistikeinrichtung-Projekt-Datei
- 6: Bauwerk
- 8: Fahrbereiche
- 10: Transportweg
- 12: Logistik-Infrastrukturelement
- 14: Rolltor
- 16: Ladehilfsmittel-Station
- 18: Ladestation
- 20: Fußgängerüberweg
- 22: Zonenüberwachungsbereich
- 22a: erster Zonenüberwachungsbereich
- 22b: zweiter Zonenüberwachungsbereich
- 23: Zonenüberwachungsvorrichtung
- 23a: erste Zonenüberwachungsvorrichtung
- 23b: zweite Zonenüberwachungsvorrichtung
- 24: Home-Station
- 25: Intralogistik-Warentransportvorrichtungen
- 26: Flurförderzeug
- 28: Planungssoftware
- 30: Rechner
- 32a, 32b: Daten-Input
- 34: Materialliste
- 36: Liste der Bauleistungen
- 38: Kostenschätzung
- 40: mobiles Endgerät
- 42: Steuerrechner
- 44: Fahrzeugleitstand
- 46: externer Rechner
- 48: Betriebsgefahrenbereich

## Patentansprüche

1. Verfahren zum Anlegen einer Warenlogistikeinrichtung (2), die folgenden Schritte umfassend:
- Erstellen (S1) einer der Warenlogistikeinrichtung (2) zugeordneten Logistikeinrichtung-Projekt-Datei (4),
- Einfügen (S2) und Speichern von Daten, die Eigenschaften zumindest einer der folgenden Komponenten der Warenlogistikeinrichtung (2) beschreiben, in die Logistikeinrichtung-Projekt-Datei (4):
- konstruktive Eigenschaften eines Bauwerks (6) der Warenlogistikeinrichtung (2),
- geometrische und/oder funktionelle Eigenschaften von Fahrbereichen (8) und/oder Transportwegen (10) in der Warenlogistikeinrichtung (2),
- geometrische und/oder funktionelle Eigenschaften von Logistik-Infrastrukturelementen (12) der Warenlogistikeinrichtung (2),
- geometrische und/oder funktionelle Eigenschaften von in der Warenlogistikeinrichtung (2) eingesetzten Intralogistik-Warentransportvorrichtungen (25), insbesondere Flurförderzeugen (26),
- Erstellen (S3) eines Planungsmodells der Warenlogistikeinrichtung (2) unter Verwendung der in der Logistikeinrichtung-Projekt-Datei (4) gespeicherten Daten,
- Realisieren (S4) der Warenlogistikeinrichtung (2) auf der Grundlage des Planungsmodells und unter Verwendung der in der Logistikeinrichtung-Projekt-Datei (4) gespeicherten Daten, wobei
- zumindest eine die Warenlogistikeinrichtung (2) im Hinblick auf ihre konstruktiven, geometrische und/oder funktionellen Eigenschaften beeinflussende oder im Hinblick auf einen Zustand der Warenlogistikeinrichtung (2) überwachende Maßnahme während des Lebenszyklus der Warenlogistikeinrichtung (2) unter Verwendung der in der Logistikeinrichtung-Projekt-Datei (4) gespeicherten Daten durchgeführt wird.

2. Verfahren nach Anspruch 1, bei dem als Maßnahme die folgenden Schritte ausgeführt werden:
- Simulieren eines Betriebs der Warenlogistikeinrichtung (2) in dem Planungsmodell der Warenlogistikeinrichtung (2),
- Optimieren des Planungsmodells der Warenlogistikeinrichtung (2) basierend auf einem Ergebnis der Simulation,
- Aktualisieren der in der Logistikeinrichtung-Projekt-Datei (4) vorhandenen Daten anhand der Ergebnisse der Optimierung,
- Erstellen eines finalisierten Planungsmodells der Warenlogistikeinrichtung (2) und
- Abspeichern der Modell-Daten des finalisierten Planungsmodells in der Logistikeinrichtung-Projekt-Datei (4), wobei insbesondere
- die Logistikeinrichtung-Projekt-Datei (4) umfasst: geometrische Daten, welche zu befahrende Transportwege (10) in der Warenlogistikeinrichtung (2) beschreiben, und geometrische Daten zu einer Mehrzahl von Logistik-Infrastrukturelementen (12), die mit den Intralogistik-Warentransportvorrichtungen (25) zusammenwirken, insbesondere von Warenübergabestationen, Ladestationen (18), Parkpositionen, Abstellplätzen und/oder Lagerplätzen, wobei der Schritt des Simulierens des Betriebs der Warenlogistikeinrichtung (2) eine Validierung der zu befahrenden Transportwege (10) umfasst, wobei insbesondere bei der Validierung der zu befahrenden Transportwege (10) überprüft wird, ob ein ferner insbesondere vollständiger, durchgehend befahrbarer Fahrspuren-Graph erstellt werden kann, der zumindest einen Teil der Logistik-Infrastrukturelemente (12), ferner insbesondere alle Logistik-Infrastrukturelemente (12), miteinander verbindet.

3. Verfahren nach Anspruch 1 oder 2, bei dem als Maßnahme die folgenden Schritte ausgeführt werden:
- Erstellen (S5) einer Materialliste (34) und/oder einer Liste (36) erforderlicher Bauleistungen für die Realisierung der Warenlogistikeinrichtung (2) unter Verwendung der in der Logistikeinrichtung-Projekt-Datei (4) gespeicherten Daten,
- Erstellen (S5) einer Kostenschätzung (38) für die Realisierung der Warenlogistikeinrichtung (2) unter Verwendung der Materialliste (34) und/oder der Liste (36) erforderlicher Bauleistungen.

4. Verfahren nach einem der Ansprüche 1 bis 3, bei dem als Maßnahme die folgenden Schritte ausgeführt werden:
- Aufnehmen (S7) eines Betriebs der Warenlogistikeinrichtung (2), wobei die Aufnahme des Betriebs ein Konfigurieren und/oder Einlernen der Logistik-Infrastrukturelemente (12) und/oder der Intralogistik-Warentransportvorrichtungen (25) umfasst und das Konfigurieren und/oder Einlernen unter Verwendung der in der Logistikeinrichtung-Projekt-Datei (4) vorhandenen Daten durchgeführt wird.

5. Verfahren nach einem der Ansprüche 1 bis 4, bei dem als Maßnahme die folgenden Schritte durchgeführt werden:
- Steuern (S7) eines laufenden Betriebs der Warenlogistikeinrichtung (2), insbesondere eines Betriebs der Logistik-Infrastrukturelemente (12) und/oder der Intralogistik-Warentransportvorrichtungen (25), durch einen Steuerrechner (42), wobei der Steuerrechner (42) eine Steuerung der Warenlogistikeinrichtung (2) unter Verwendung der in der Logistikeinrichtung-Projekt-Datei (4) vorhandenen Daten vornimmt.

6. Verfahren nach einem der Ansprüche 1 bis 5, bei dem als Maßnahme die folgenden Schritte durchgeführt werden:
- Visualisieren (S8) der Warenlogistikeinrichtung (2) im Betrieb unter Verwendung der in der Logistikeinrichtung-Projekt-Datei (4) vorhandenen Daten oder daraus abgeleiteten Daten, wobei
- die Logistikeinrichtung-Projekt-Datei (4) insbesondere umfasst:
- Abmessungen des Bauwerks (6) als konstruktive Eigenschaften des Bauwerks (6),
- Abmessungen und/oder Positionen von Logistik-Infrastrukturelementen (12) als geometrische Eigenschaften der Logistik-Infrastrukturelemente (12) und
- Abmessungen von Intralogistik-Warentransportvorrichtungen (25) als geometrische Eigenschaften der Intralogistik-Warentransportvorrichtungen (25), wobei
- die Visualisierung eine grafische Darstellung des Bauwerks (6) der Warenlogistikeinrichtung (2) umfasst, und wobei eine Geometrie dieser Darstellung unter Berücksichtigung der Abmessungen des Bauwerks (6) erfolgt, insbesondere in zumindest näherungsweise maßstabsgetreuer Darstellung erfolgt,
- die Visualisierung eine grafische Darstellung der Logistik-Infrastrukturelemente (12) unter Berücksichtigung der Abmessungen, insbesondere in zumindest näherungsweise maßstabsgetreuer Darstellung, und/oder der Positionen der Logistik-Infrastrukturelemente (12) umfasst, und
- die Visualisierung eine grafische Darstellung der Intralogistik-Warentransportvorrichtungen (25) unter Berücksichtigung der Abmessungen, insbesondere in zumindest näherungsweise maßstabsgetreuer Darstellung, der Intralogistik-Warentransportvorrichtungen (25) umfasst und wobei ferner insbesondere
- die Logistikeinrichtung-Projekt-Datei (4) umfasst:
- funktionelle Eigenschaften der in der Warenlogistikeinrichtung (2) vorhandenen Logistik-Infrastrukturelemente (12) und/oder Intralogistik-Warentransportvorrichtungen (25), wobei die Visualisierung eine Darstellung eines aktuellen Funktionszustands der Logistik-Infrastrukturelemente (12) und/oder der Intralogistik-Warentransportvorrichtungen (25) umfasst und wobei ferner insbesondere
- die Visualisierung eine Darstellung einer aktuellen Position und/oder von Staus der Intralogistik-Warentransportvorrichtungen (25) umfasst.

7. Verfahren nach den Ansprüchen 5 und 6, wobei die Maßnahme des Visualisierens der Warenlogistikeinrichtung ferner umfasst:
- Visualisieren (S8) der Warenlogistikeinrichtung (2) an einem mit dem Steuerrechner (42) gekoppelten Fahrzeugleitstand (44), wobei die Logistikeinrichtung-Projekt-Datei (4) und/oder aus dieser abgeleitete oder extrahierte Daten entweder in dem Fahrzeugleitstand (44) hinterlegt sind oder über eine Datenverbindung zwischen dem Fahrzeugleitstand (44) und dem Steuerrechner (42) an den Fahrzeugleitstand (44) übermittelt werden, wobei insbesondere
- der Steuerrechner (42) einem externen Rechner (46) Zugriff auf die Logistikeinrichtung-Projekt-Datei (4) und/oder den in der Logistikeinrichtung-Projekt-Datei (4) gespeicherte Daten und/oder aus der Logistikeinrichtung-Projekt-Datei (4) abgeleitete oder extrahierte Daten gewährt und der externe Rechner (46) die Warenlogistikeinrichtung (2) visualisiert, wobei der externe Rechner (46) insbesondere eine aktuelle Position der Intralogistik-Warentransportvorrichtungen (25) und/oder einen Betriebsstatus der Logistik-Infrastrukturelemente (12) visualisiert, um eine Diagnose von Fehlfunktionen der Warenlogistikeinrichtung (2) zu ermöglichen.

8. Verfahren nach einem der Ansprüche 1 bis 7, bei dem als Maßnahme die folgenden Schritte durchgeführt werden:
- Durchführen einer Fernwartung (S10) der Warenlogistikeinrichtung (2) im Betrieb, wobei insbesondere einem bei der Fernwartung verwendeten externen Rechner (46) von dem Steuerrechner (42) Zugriff gewährt wird auf die Logistikeinrichtung-Projekt-Datei (4) und/oder in der Logistikeinrichtung-Projekt-Datei (4) gespeicherte Daten und/oder aus der Logistikeinrichtung-Projekt-Datei (4) abgeleitete oder extrahierte Daten, die auf dem Steuerrechner (42) gespeichert sind.

9. Verfahren nach einem der Ansprüche 1 bis 8, bei dem als Maßnahme die folgenden Schritte durchgeführt werden:
- Erweitern und/oder Ändern der Warenlogistikeinrichtung (2) unter Anpassung der in der Logistikeinrichtung-Projekt-Datei (4) vorhandenen Daten, wobei die Erweiterung und/oder die Änderung zumindest eine der folgenden Maßnahmen umfasst:
- Anpassung von geometrischen Daten, beschreibend das Bauwerk (6) der Warenlogistikeinrichtung (2), insbesondere von Maßen des Bauwerks (6),
- Anpassen von geometrischen und/oder funktionellen Eigenschaften der Logistik-Infrastrukturelemente (12),
- Austauschen und/oder Ergänzen von Intralogistik-Warentransportvorrichtungen (25) oder Änderung eines Typs der Intralogistik-Warentransportvorrichtungen (25),
- Austauschen und/oder Ergänzen der Logistik-Infrastrukturelemente (12),
- Verändern von geometrischen Daten, welche erlaubte Fahrbereiche (8) und/oder Transportwege (10) in der Warenlogistikeinrichtung (2) beschreiben,
- Verändern geometrischer Daten und/oder funktioneller Daten der Logistik-Infrastrukturelemente (12),
- Verändern geometrischer Daten und/oder funktioneller Daten der in der Warenlogistikeinrichtung (2) eingesetzten Intralogistik-Warentransportvorrichtungen (25).

10. Computerlesbares Speichermedium, auf dem eine Logistikeinrichtung-Projekt-Datei (4) zur Verwendung in einem Verfahren nach einem der Ansprüche 1 bis 9 gespeichert ist.

11. Warenlogistikeinrichtung (2), realisiert auf der Grundlage eines Planungsmodells und unter Verwendung von in einer Logistikeinrichtung-Projekt-Datei (4) gespeicherten Daten, wobei die Logistikeinrichtung-Projekt-Datei (4) Daten umfasst, die Eigenschaften zumindest einer der folgenden Komponenten der Warenlogistikeinrichtung (2) beschreiben:
- konstruktive Eigenschaften eines Bauwerks (6) der Warenlogistikeinrichtung (2),
- geometrische und/oder funktionelle Eigenschaften von Fahrbereichen (8) und/oder Transportwegen (10) in der Warenlogistikeinrichtung (2),
- geometrische und/oder funktionelle Eigenschaften von Logistik-Infrastrukturelementen (12) der Warenlogistikeinrichtung (2),
- geometrische und/oder funktionelle Eigenschaften von in der Warenlogistikeinrichtung (2) eingesetzten Intralogistik-Warentransportvorrichtungen (25), insbesondere Flurförderzeugen (26),
- wobei das Planungsmodell der Warenlogistikeinrichtung (2) unter Verwendung der in der Logistikeinrichtung-Projekt-Datei (4) gespeicherten Daten erstellt ist, und die Logistikeinrichtung-Projekt-Datei (4) während des Lebenszyklus der Warenlogistikeinrichtung (2) ferner für zumindest eine Maßnahme verwendet wird, welche die Warenlogistikeinrichtung (2) im Hinblick auf ihre konstruktiven, geometrische und/oder funktionellen Eigenschaften beeinflusst oder im Hinblick auf einen Zustand der Warenlogistikeinrichtung (2) überwacht.

12. Warenlogistikeinrichtung (2) nach Anspruch 11, ferner umfassend einen Steuerrechner, der dazu eingerichtet ist die folgenden Schritte durchzuführen:
- Steuern eines laufenden Betriebs der Warenlogistikeinrichtung (2), insbesondere eines Betriebs der Logistik-Infrastrukturelemente (12) und/oder der Intralogistik-Warentransportvorrichtungen (25), wobei der Steuerrechner (42) eine Steuerung der Warenlogistikeinrichtung (2) unter Verwendung der in der Logistikeinrichtung-Projekt-Datei (4) vorhandenen Daten vornimmt.

13. Warenlogistikeinrichtung (2) nach Anspruch 11 oder 12, umfassend einen Steuerrechner (42), der dazu eingerichtet ist die folgenden Schritte durchzuführen:
- Visualisieren der Warenlogistikeinrichtung (2) im Betrieb unter Verwendung der in der Logistikeinrichtung-Projekt-Datei (4) vorhandenen Daten, wobei
- die Logistikeinrichtung-Projekt-Datei (4) insbesondere umfasst:
- Abmessungen des Bauwerks (6) als konstruktive Eigenschaften des Bauwerks (6),
- Abmessungen und/oder Positionen von Logistik-Infrastrukturelementen (12) als geometrische Eigenschaften der Logistik-Infrastrukturelemente (12) und
- Abmessungen von Intralogistik-Warentransportvorrichtungen (25) als geometrische Eigenschaften der Intralogistik-Warentransportvorrichtungen (25), wobei
- der Steuerrechner (42) die Visualisierung als eine grafische Darstellung vornimmt, wobei
- eine Geometrie der Darstellung des Bauwerks (6) der Warenlogistikeinrichtung (2) unter Berücksichtigung der Abmessungen des Bauwerks (6) erfolgt, insbesondere in zumindest näherungsweise maßstabsgetreuer Darstellung erfolgt,
- die grafische Darstellung der Logistik-Infrastrukturelemente (12) unter Berücksichtigung der Abmessungen, insbesondere in zumindest näherungsweise maßstabsgetreuer Darstellung, und/oder der Positionen der Logistik-Infrastrukturelemente (12) erfolgt, und
- die grafische Darstellung der Intralogistik-Warentransportvorrichtungen (25) unter Berücksichtigung der Abmessungen, insbesondere in zumindest näherungsweise maßstabsgetreuer Darstellung, der Intralogistik-Warentransportvorrichtungen (25) erfolgt und wobei ferner insbesondere
- die Logistikeinrichtung-Projekt-Datei (4) umfasst:
- funktionelle Eigenschaften der in der Warenlogistikeinrichtung (2) vorhandenen Logistik-Infrastrukturelemente (12) und/oder Intralogistik-Warentransportvorrichtungen (25), wobei die Visualisierung eine Darstellung eines aktuellen Funktionszustands der Logistik-Infrastrukturelemente (12) und/oder der Intralogistik-Warentransportvorrichtungen (25) umfasst und wobei ferner insbesondere
- die Visualisierung eine Darstellung einer aktuellen Position und/oder von Staus der Intralogistik-Warentransportvorrichtungen (25) umfasst.

14. Warenlogistikeinrichtung (2) nach einem der Ansprüche 11 bis 13, umfassend einen Steuerrechner (42), der dazu eingerichtet ist einem externen Rechner (46) Zugriff auf die Logistikeinrichtung-Projekt-Datei (4) und/oder in der Logistikeinrichtung-Projekt-Datei (4) gespeicherte Daten und/oder aus der Logistikeinrichtung-Projekt-Datei (4) abgeleitete oder extrahierte Daten zu gewähren und der externe Rechner (46) dazu eingerichtet ist die Warenlogistikeinrichtung (2) zu visualisieren, insbesondere eine aktuelle Position der Intralogistik-Warentransportvorrichtungen (25) und/oder einen Betriebsstatus der Logistik-Infrastrukturelemente (12) zu visualisieren, um eine Diagnose von Fehlfunktionen der Warenlogistikeinrichtung (2) zu ermöglichen, und/oder eine Fernwartung durchzuführen.

15. Warenlogistikeinrichtung (2) nach einem der Ansprüche 11 bis 14, umfassend einen Steuerrechner (42), der dazu eingerichtet ist die Logistikeinrichtung-Projekt-Datei (4) zur Durchführung der folgenden Maßnahme zu verwenden:
- Erweitern und/oder Ändern der Warenlogistikeinrichtung (2) unter Anpassung der in der Logistikeinrichtung-Projekt-Datei (4) vorhandenen Daten, wobei die Erweiterung und/oder die Änderung zumindest eine der folgenden Maßnahmen umfasst:
- Anpassung von geometrischen Daten, beschreibend das Bauwerk (6) der Warenlogistikeinrichtung (2), insbesondere von Maßen des Bauwerks (6),
- Anpassen von geometrischen und/oder funktionellen Eigenschaften der Logistik-Infrastrukturelemente (12),
- Austauschen und/oder Ergänzen von Intralogistik-Warentransportvorrichtungen (25) oder Änderung eines Typs der Intralogistik-Warentransportvorrichtungen (25),
- Austauschen und/oder Ergänzen der Logistik-Infrastrukturelemente (12),
- Verändern von geometrischen Daten, welche erlaubte Fahrbereiche (8) und/oder Transportwege (10) in der Warenlogistikeinrichtung (2) beschreiben,
- Verändern geometrischer Daten und/oder funktioneller Daten der Logistik-Infrastrukturelemente (12),
- Verändern geometrischer Daten und/oder funktioneller Daten der in der Warenlogistikeinrichtung (2) eingesetzten Intralogistik-Warentransportvorrichtungen (25).
